# EUROPEAN PATENT APPLICATION

(11) **EP 4 700 825 A1**
(43) Date of publication of application: **25.02.2026**
(21) Application number: 25162538.0
(22) Date of filing: 10.03.2025
(51) Int. Cl.: H01L 21/768, H10B 43/27

(54) **SEMICONDUCTOR DEVICE AND ELECTRONIC SYSTEM INCLUDING THE SAME**

(30) Priority: 19.08.2024 KR 20240110459
(71) Applicant: Samsung Electronics Co., Ltd., Suwon-si, Gyeonggi-do 16677 (KR)
(72) Inventor: SON, Yongseok, 16677 Suwon-si, Gyeonggi-do (KR); KIM, Hyuk, 16677 Suwon-si, Gyeonggi-do (KR); LEE, Yuna, 16677 Suwon-si, Gyeonggi-do (KR); PARK, Sangjun, 16677 Suwon-si, Gyeonggi-do (KR); CHOI, Jeong-Hee, 16677 Suwon-si, Gyeonggi-do (KR)
(74) Representative: Kuhnen & Wacker Patent- und Rechtsanwaltsbüro PartG mbB

(57) **Abstract**

A semiconductor device includes a memory cell structure in a cell array region (102), an electrode stacking structure (120) including a plurality of electrodes (130) and a plurality of interlayer insulation layers alternately stacked in a connection region, and a plurality of electrode contact portions (190) penetrating at least a partial portion of the electrode stacking structure (120) and are electrically connected to the plurality of electrodes (130). The plurality of electrode contact portions (190) include first and second contact portions (196). The first contact portion (192) includes a first conductive portion (192c), and a first side insulation layer (192i) between the electrode stacking structure (120) and the first conductive portion (192c). The second contact portion (196) includes a second conductive portion (196c), and a second side insulation layer (196i) between the electrode stacking structure (120) and the second conductive portion (196c). The second side insulation layer (196i) has a shape or a structure different from a shape or a structure of the first side insulation layer (192i).

## Description

### BACKGROUND

### (a) Field

The present disclosure relates to a semiconductor device and an electronic system including the same.

### (b) Description of the Related Art

In an electronic system implementing a data storage, a semiconductor device capable of storing high-capacity data is in demand. Accordingly, strategies for increasing a data storage capacity of a semiconductor device are being researched. For example, as one strategy for increasing the data storage capacity of a semiconductor device, a semiconductor device including three-dimensionally arranged memory cells instead of two-dimensionally arranged memory cells has been proposed.

### SUMMARY

The present disclosure attempts to provide a semiconductor device capable of enhancing reliability and productivity and an electronic system including the same.

A semiconductor device according to an example embodiment includes a memory cell structure in a cell array region, an electrode stacking structure that includes a plurality of electrodes and a plurality of interlayer insulation layers alternately stacked on each other at least in a connection region, and a plurality of electrode contact portions that pass through or penetrate at least a partial portion of the electrode stacking structure and are electrically connected to the plurality of electrodes, respectively. The plurality of electrode contact portions include a first contact portion and a second contact portion. The first contact portion includes a first conductive portion, and a first side insulation layer between the electrode stacking structure and the first conductive portion. The second contact portion includes a second conductive portion, and a second side insulation layer between the electrode stacking structure and the second conductive portion. The second side insulation layer has a shape or a structure different from a shape or a structure of the first side insulation layer.

An electronic system according to an example embodiment includes a main substrate, a semiconductor device on the main substrate, and a controller that is electrically connected to the semiconductor device on the main substrate. The semiconductor device includes a memory cell structure in a cell array region, an electrode stacking structure that includes a plurality of electrodes and a plurality of interlayer insulation layers alternately stacked on each other at least in a connection region, and a plurality of electrode contact portions that pass through or penetrate at least a partial portion of the electrode stacking structure and are electrically connected to the plurality of electrodes, respectively. The plurality of electrode contact portions include a first contact portion and a second contact portion. The first contact portion includes a first conductive portion, and a first side insulation layer between the electrode stacking structure and the first conductive portion. The second contact portion includes a second conductive portion, and a second side insulation layer between the electrode stacking structure and the second conductive portion. The second side insulation layer has a shape or a structure different from a shape or a structure of the first side insulation layer.

A semiconductor device according to an example embodiment includes a memory cell structure in a cell array region, an electrode stacking structure that includes a plurality of electrodes and a plurality of interlayer insulation layers alternately stacked on each other at least in a connection region, and a plurality of electrode contact portions that pass through or penetrate at least a partial portion of the electrode stacking structure and are electrically connected to the plurality of electrodes, respectively. At least one of the plurality of electrode contact portions includes a conductive portion, and a side insulation layer between the electrode stacking structure and the conductive portion. The side insulation layer includes a first portion that is disposed at an upper portion of the at least one of the plurality of electrode contact portions, and a second portion that has a thickness less than a thickness of the first portion and is disposed at a lower portion of the first portion or under the first portion.

According to an example embodiment, a plurality of through holes may be formed using partial etching processes according to binary system, and a process of forming gate contact portions may be simplified and an area of a connection region may be reduced. A first layer that is at least a partial portion of a side insulation layer may be formed before a succeeding partial etching process, and damage to a stacking structure or an electrode stacking structure that may be induced in the succeeding partial etching process may be prevented and a through hole that has a relatively large depth may be stably formed. Thereby, reliability and productivity of a semiconductor device may be enhanced.

### BRIEF DESCRIPTION OF THE DRAWINGS

FIG. 1 is a partial cross-sectional view that schematically illustrates a semiconductor device according to an example embodiment.
FIG. 2 is an enlarged partial cross-sectional view that illustrates an example of a channel structure included in the semiconductor device illustrated in FIG. 1.
FIG. 3 is a cross-sectional view that illustrates a connection region of a cell region included in the semiconductor device illustrated in FIG. 1.
FIG. 4 is a cross-sectional view that illustrates a portion A of FIG. 3.
FIG. 5 is a cross-sectional view that illustrates a portion B of FIG. 3.
FIG. 6 is a cross-sectional view that illustrates a portion C of FIG. 3.
FIG. 7 to FIG. 18 are cross-sectional views that illustrate an example manufacturing method of a semiconductor device.
FIG. 19 is a cross-sectional view that illustrates a gate contact portion included in a semiconductor device according to an example embodiment.
FIG. 20 is a cross-sectional view that illustrates a gate contact portion included in a semiconductor device according to an example embodiment.
FIG. 21 is a cross-sectional view that illustrates a gate contact portion included in a semiconductor device according to an example embodiment.
FIG. 22 is a cross-sectional view that schematically illustrates a semiconductor device according to an example embodiment.
FIG. 23 is a view that schematically illustrates an electronic system including a semiconductor device according to an example embodiment.
FIG. 24 is a view that schematically illustrates an electronic system including a semiconductor device according to an example embodiment.
FIG. 25 is a perspective view that schematically illustrates a semiconductor package including a semiconductor device according to an example embodiment.
FIG. 26 is a perspective view that schematically illustrates a semiconductor package including a semiconductor device according to an example embodiment.

### DETAILED DESCRIPTION

Embodiments of the present disclosure will be described more fully hereinafter with reference to the accompanying drawings for those skilled in the art to which the present disclosure pertains to easily practice the present disclosure. The present disclosure may be implemented in various different forms and is not limited to the embodiment provided herein.

A portion unrelated to the description is omitted in order to clearly describe the present disclosure, and the same or similar components are denoted by the same reference numeral throughout the present specification.

Further, since a size and/or a thickness of a portion, a region, a member, a unit, a layer, a film, a substrate, or so on illustrated in the accompanying drawings may be arbitrarily illustrated for better understanding and convenience of explanation, the present disclosure is not limited to the illustrated size and/or thickness. In the drawings, a thickness of a portion, a region, a member, a unit, a layer, a film, a substrate, or so on may be enlarged or exaggerated for convenience of explanation and/or simple illustration

It will be understood that when a component such as a portion, a region, a member, a unit, a layer, a film, a substrate, or so on is referred to as being "on" another component, it may be directly on another component or an intervening component may also be present. In contrast, when a component is referred to as being "directly on" another component, there is no intervening component present. Further, when a component is referred to as being "on" or "above" a reference component, a component may be disposed on or below the reference component, and does not necessarily be "on" or "above" the reference component toward an opposite direction of gravity. In contrast, when an element is referred to as being "directly connected" or "directly coupled" to another element, or as "contacting" or "in contact with" another element (or using any form of the word "contact"), there are no intervening elements present at the point of contact.

In addition, throughout the specification, unless explicitly described to the contrary, the word "comprise", "include", or "contain", and variations such as "comprises", "comprising", "includes", "including", "contains" or "containing" will be understood to imply the inclusion of other components rather than the exclusion of any other components.

Further, throughout the specification, a phrase "on a plane", "in a plane", "on a plan view", or "in a plan view" may indicate a case where a portion is viewed from above or a top portion, and a phrase "on a cross-section" or "in a cross-sectional view" may indicate a case where a cross-section taken along a vertical direction is viewed from a side.

Terms such as "same," "equal," "planar," or "coplanar," as used herein when referring to orientation, layout, location, shapes, sizes, amounts, or other measures do not necessarily mean an exactly identical orientation, layout, location, shape, size, amount, or other measure, but are intended to encompass nearly identical orientation, layout, location, shapes, sizes, amounts, or other measures within acceptable variations that may occur, for example, due to manufacturing processes. The term "substantially" may be used herein to emphasize this meaning, unless the context or other statements indicate otherwise. For example, items described as "substantially the same," "substantially equal," or "substantially planar," may be exactly the same, equal, or planar, or may be the same, equal, or planar within acceptable variations that may occur, for example, due to manufacturing processes.

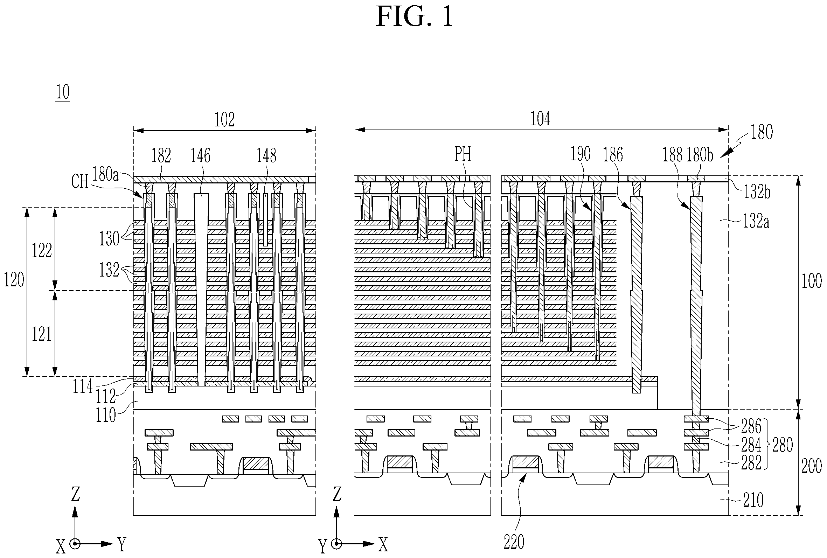

Hereinafter, referring to FIG. 1 to FIG. 18, a semiconductor device according to an example embodiment and a manufacturing method of the same will be described in detail.

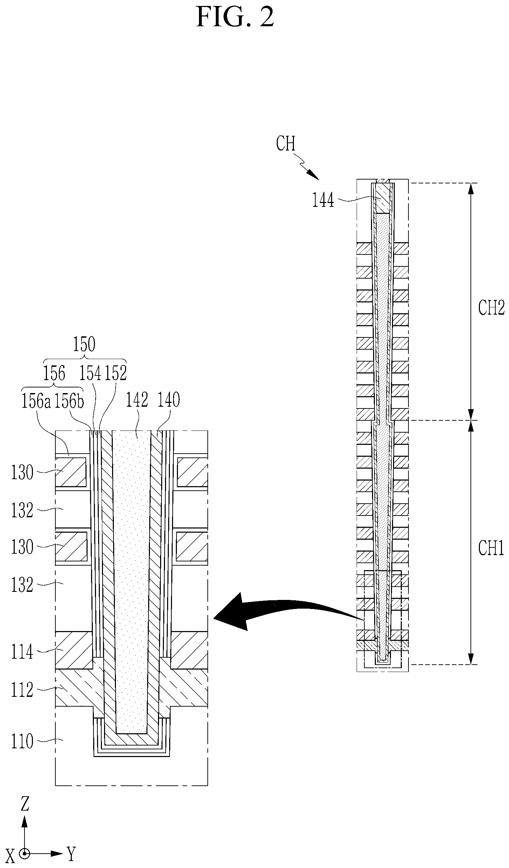

FIG. 1 is a partial cross-sectional view that schematically illustrates a semiconductor device 10 according to an example embodiment. FIG. 2 is an enlarged partial cross-sectional view that illustrates an example of a channel structure CH included in the semiconductor device 10 illustrated in FIG. 1.

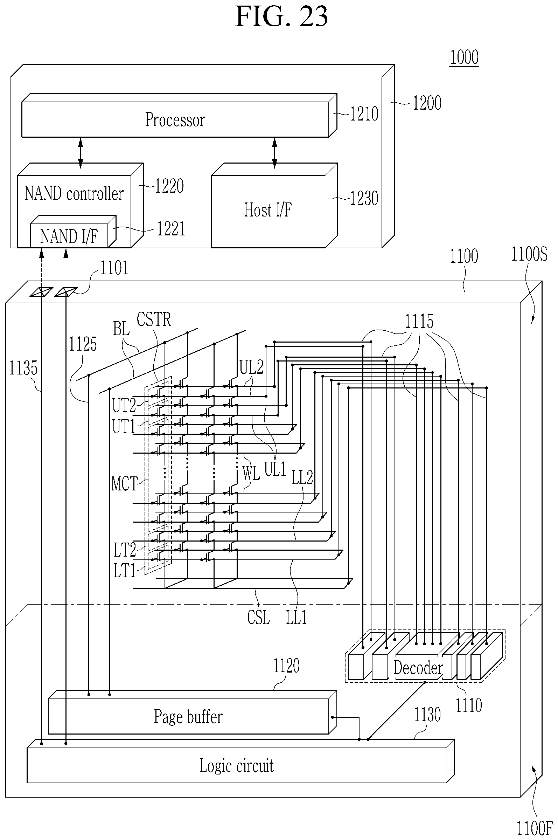

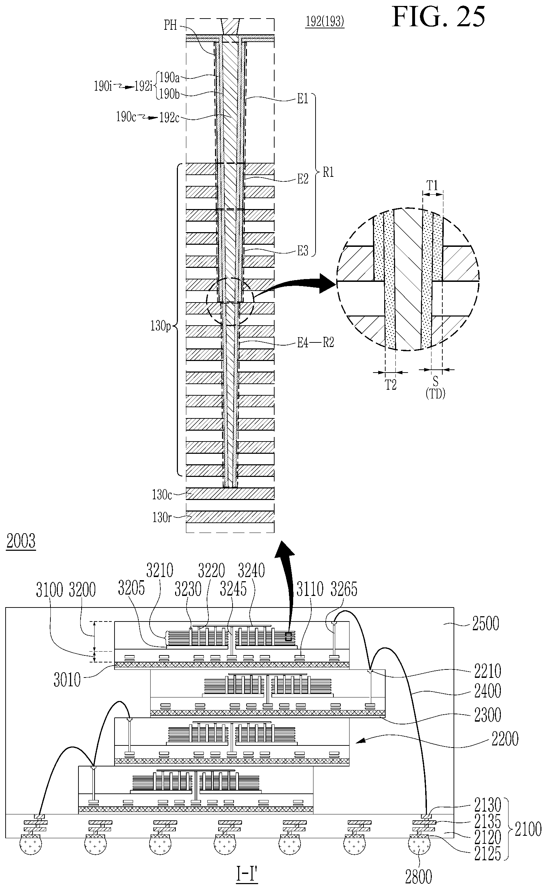

Referring to FIG. 1 and FIG. 2, a semiconductor device 10 according to an embodiment may include a cell region 100 that includes a memory cell structure and a circuit region 200 that includes a peripheral circuit structure configured to control an operation of the memory cell structure. For example, the circuit region 200 and the cell region 100 may correspond to a first structure 1100F and a second structure 1100S of a semiconductor device 1100 included in an electronic system 1000 illustrated in FIG. 23, respectively. For example, the circuit region 200 and the cell region 100 may be portions including a first structure 3100 and a second structure 3200 of a semiconductor chip 2200 illustrated in FIG. 25, respectively.

The circuit region 200 may include the peripheral circuit structure on a first substrate 210, and the cell region 100 may include a gate stacking structure 120 (which is an example of an electrode stacking structure) and a channel structure CH on a second substrate 110 as the memory cell structure. The circuit region 200 may include a first wiring portion 280, and the cell region 100 may include a second wiring portion 180 electrically connected to the memory cell structure.

In an embodiment, the cell region 100 may be disposed on the circuit region 200. Accordingly, an area corresponding to the circuit region 200 does not need to be secured separately from the cell region 100. Therefore, an area of the semiconductor device 10 may be reduced. However, the embodiments are not limited thereto, and the circuit region 200 may be disposed next to the cell region 100. Other various modifications are possible.

The circuit region 200 may include a first substrate 210, and a circuit element 220 and the first wiring portion 280 on the first substrate 210.

The first substrate 210 may be a semiconductor substrate including a semiconductor material. For example, the first substrate 210 may be a semiconductor substrate including or being formed of a semiconductor material or may be a semiconductor substrate in which a semiconductor layer is on a base substrate. For example, the first substrate 210 may include or be formed of single-crystalline or polycrystalline silicon, epitaxial silicon, germanium, silicon-germanium, silicon on insulator (SOI), germanium on insulator (GOI), or so on.

The circuit element 220 on the first substrate 210 may include any of various circuit elements that control an operation of the memory cell structure in the cell region 100. For example, the circuit element 220 may constitute the peripheral circuit structure such as a decoder circuit 1110 (refer to FIG. 23), a page buffer 1120 (refer to FIG. 23), a logic circuit 1130 (refer to FIG. 23), or so on.

The circuit element 220 may include, for example, a plurality of transistors, but the embodiments are not limited thereto. For example, the circuit element 220 may include not only an active element such as the transistor or so on but also a passive element such as a capacitor, a resistor, an inductor, or so on.

The first wiring portion 280 on the first substrate 210 may be electrically connected to the circuit element 220. In an embodiment, the first wiring portion 280 may include a plurality of wiring layers 286 that are spaced apart from each other while interposing an interlayer insulation layer 282 therebetween and are electrically connected by contact vias 284 to form a desired path. The wiring layers 286 or the contact vias 284 may include any of various conductive materials, and the interlayer insulation layer 282 may include any of various insulating materials. For example, the interlayer insulation layer 282 may include or be formed of at least one of silicon oxide, silicon nitride, or silicon oxynitride.

The cell region 100 may include a cell array region 102 and a connection region 104. The gate stacking structure 120 and the channel structure CH may be on the second substrate 110 in the cell array region 102. A structure that connects the gate stacking structure 120 and/or the channel structure CH in the cell array region 102 to the circuit region 200 or an external circuit may be in the cell array region 102 and/or the connection region 104.

In an embodiment, the second substrate 110 may include a semiconductor layer including a semiconductor material. For example, the second substrate 110 may be a semiconductor substrate including or being formed of a semiconductor material or may be a semiconductor substrate in which a semiconductor layer is on a base substrate. For example, the second substrate 110 may include or be formed of silicon, germanium, silicon-germanium, silicon on insulator (SOI), germanium on insulator (GOI), or so on. A p-type dopant or an n-type dopant may be doped to the semiconductor layer included in the second substrate 110. For example, the p-type dopant may include boron (B), gallium (Ga), or so on, or the n-type dopant may include phosphorus (P), arsenic (As), or so on. However, the embodiments are not limited to a material of the second substrate 110, a conductive type of the dopant doped to the semiconductor layer, or so on.

In the cell array region 102, the gate stacking structure 120 and the channel structure CH may be disposed. The gate stacking structure 120 may include interlayer insulation layers 132 and gate electrodes 130 (which is an example of electrodes) alternately stacked on a first surface (e.g., a front surface or an upper surface) of the second substrate 110. The channel structure CH may extend in a direction crossing (e.g., perpendicular to) the second substrate 110 (a Z-axis direction in the drawings) while penetrating the gate stacking structure 120. Herein, the X-axis direction and the Y-axis direction may be perpendicular to each other and parallel to an upper surface of the second substrate 110, and may be referred to as horizontal directions. The Z-axis direction may be perpendicular to both the X-axis direction and the Y-axis direction, and may be referred to as a vertical direction. The Z-axis direction may be perpendicular to the upper surface of the second substrate 110.

In an embodiment, horizontal conductive layers 112 and 114 may be provided between the second substrate 110 and the gate stacking structure 120 in the cell array region 102. The horizontal conductive layers 112 and 114 may electrically connect (e.g., directly connect) the channel structure CH and the second substrate 110. The horizontal conductive layers 112 and 114 may include a first horizontal conductive layer 112 and/or a second horizontal conductive layer 114 sequentially stacked on the second substrate 110. The first horizontal conductive layer 112 may act as a partial portion of a common source line of the semiconductor device 10. For example, the first horizontal conductive layer 112 may act as the common source line together with the second substrate 110.

The first and second horizontal conductive layers 112 and 114 may include a semiconductor material (e.g., polycrystalline silicon). For example, the first horizontal conductive layer 112 may include a polycrystalline silicon layer including a dopant. The embodiments are not limited thereto. The second horizontal conductive layer 114 may include a material (e.g., an insulating material) different from a material of the first horizontal conductive layer 112, or the second horizontal conductive layer 114 may be omitted.

The gate stacking structure 120 where the interlayer insulation layers 132 and the gate electrodes 130 are alternately stacked on each other may be disposed on the second substrate 110 (e.g., on the first and second horizontal conductive layers 112 and 114 disposed on the second substrate 110).

The gate electrode 130 may include any of various conductive materials. For example, the gate electrode 130 may include or be formed of a metal material (e.g., tungsten (W), copper (Cu), aluminum (Al), or so on), polycrystalline silicon, metal nitride (e.g., titanium nitride (TiN), tantalum nitride (TaN), or so on), or a combination thereof. As illustrated in an enlarged portion of FIG. 2, a partial portion (e.g., a first blocking layer 156a) of a blocking layer 156 that includes or is formed of an insulating material may be disposed outside the gate electrode 130. For example, the first blocking layer 156a may contact upper, lower, and side surfaces of the gate electrodes 130. The interlayer insulation layer 132 may include any of various insulating materials. For example, the interlayer insulation layer 132 may include or be formed of silicon oxide, silicon nitride, silicon oxynitride, a low dielectric constant material having a lower dielectric constant than silicon oxide, or a combination thereof.

In an embodiment, the channel structure CH may be provided. The channel structure CH may extend in a direction crossing the second substrate 110 (e.g., a direction perpendicular to the second substrate 110 or the Z-axis direction in the drawings) to penetrate the gate stacking structure 120.

The channel structure CH may include a channel layer 140, and a gate dielectric layer 150 on the channel layer 140 between the gate electrode 130 and the channel layer 140. The channel structure CH may further include a core insulation layer 142 at an inside of the channel layer 140. In some embodiments, the core insulation layer 142 may be omitted. The channel structure CH may further include a channel pad 144 on the channel layer 140 and/or the core insulation layer 142. The channel pad 144 may contact an upper surface of the core insulation layer 142. The gate dielectric layer 150 between the gate electrode 130 and the channel layer 140 may include a tunneling layer 152, a charge storage layer 154, and a blocking layer 156 sequentially on the channel layer 140. The tunneling layer 152 may contact side and bottom surfaces of the channel layer 140, the charge storage layer 154 may contact side and bottom surfaces of the tunneling layer 152, and the blocking layer 156 may contact side and bottom surfaces of the charge storage layer 154.

Each channel structure CH forms one memory cell string, and a plurality of channel structures CH may be spaced apart from each other while forming rows and columns in a plan view. For example, a plurality of channel structures CH may be disposed to form any of various shapes such as a lattice shape, a zigzag shape, or so on in a plan view. The channel structure CH may have a pillar shape. For example, in a cross-sectional view, the channel structure CH may have an inclined side surface such that a width of the channel structure CH decreases toward the second substrate 110 due to a high aspect ratio. However, the embodiments are not limited thereto, and an arrangement, a structure, a shape, or so on of the channel structure CH may be variously modified.

The channel layer 140 may include a semiconductor material (e.g., polycrystalline silicon). The core insulation layer 142 may include any of various insulating materials. For example, the core insulation layer 142 may include or be formed of silicon oxide, silicon nitride, silicon oxynitride, or a combination thereof.

The tunneling layer 152 may include an insulating material that is capable of tunneling a charge (e.g., silicon oxide, silicon oxynitride, or so on). The charge storage layer 154 may be used as a data storage region, and the charge storage layer 154 may include polycrystalline silicon, silicon nitride, or so on. The blocking layer 156 may include an insulating material that is capable of preventing an undesirable flow of charge into the gate electrode 130. The blocking layer 156 may include, for example, silicon oxide, silicon nitride, silicon oxynitride, a high dielectric constant material having a higher dielectric constant than silicon oxide, or a combination thereof. In an embodiment, the blocking layer 156 may include a first blocking layer 156a that includes a portion horizontally extending on the gate electrode 130, and a second blocking layer 156b that vertically extends between the first blocking layer 156a and the charge storage layer 154.

However, materials, stacking structures, or so on of the channel layer 140, the core insulation layer 142, and the gate dielectric layer 150 may be variously modified, and the embodiments are not limited thereto.

The channel pad 144 may cover an upper surface of the core insulation layer 142 and be disposed to be electrically connected to the channel layer 140. For example, the channel pad 144 may contact an upper surface of the core insulation layer 142. The channel pad 144 may include a conductive material (e.g., polycrystalline silicon doped with a dopant), but the embodiments are not limited thereto.

In an embodiment, the gate stacking structure 120 may include a plurality of gate stacking portions 121 and 122 that are sequentially stacked. Each of the plurality of gate stacking portions 121 and 122 may include at least a portion of the interlayer insulation layers 132 and the gate electrodes 130 that are alternately stacked on each other. Thereby, a number of stacked gate electrodes 130 may increase and thus a number of memory cells may increase with a stable structure. In FIG. 1, it is illustrated as an example that the gate stacking structure 120 includes first and second gate stacking portions 121 and 122. In some embodiments, the gate stacking structure 120 may include one gate stacking portion or three or more gate stacking portions.

When the plurality of gate stacking portions 121 and 122 are provided as in the above, the channel structure CH may include a plurality of channel portions CH1 and CH2 that respectively pass through the plurality of gate stacking portions 121 and 122. For example, the channel portions CH1 may penetrate the gate stacking portion 122, and the channel portions CH2 may penetrate the gate stacking portion 121. The plurality of channel portions CH1 and CH2 may be connected to each other. In a cross-sectional view, each of the plurality of channel portions CH1 and CH2 may have an inclined side surface such that a width of each of the plurality of channel portions CH1 and CH2 decreases toward the second substrate 110 due to a high aspect ratio. A bent portion due to a difference in widths of the plurality of channel portions CH1 and CH2 may be provided at a connection portion of the plurality of channel portions CH1 and CH2. In some embodiments, the plurality of channel portions CH1 and CH2 may have an inclined side surface that continuously extends without the bent portion. In FIG. 2, it is illustrated as an example that each of the gate dielectric layer 150, the channel layer 140, and the core insulation layer 142 of the plurality of channel portions CH1 and CH2 continuously extends to have an integral structure. In some embodiments, gate dielectric layers 150, channel layers 140, and core insulation layers 142 of a plurality of channel portions CH1 and CH2 may be separately formed and be electrically connected to each other. In some embodiments, a separate channel pad may be additionally disposed at the connection portion of the plurality of channel portions CH1 and CH2. As such, the embodiments are not limited to a shape of the plurality of channel portions CH1 and CH2.

In an embodiment, the gate stacking structure 120 may be divided into a plurality of portions in a plan view by a separation structure 146. The separation structure 146 may extend in the direction (e.g., the Z-axis direction in the drawings) crossing (e.g., perpendicular to) the second substrate 110 to pass through or penetrate the gate stacking structure 120. In example embodiments, a bottom surface of the separation region 148 may contact an upper surface of the second substrate 110. An upper separation region 148 may be disposed at an upper portion of the gate stacking structure 120. For example, the upper separation region 148 may extend through upper ones of the interlayer insulation layers 132 and the gate electrodes 130. In a plan view, the separation structure 146 and/or the upper separation region 148 may extend lengthwise in an extension direction of the gate electrode 130 (the X-axis direction in the drawings). A plurality of separation structures 146 and/or a plurality of upper separation regions 148 may be spaced apart from each other at predetermined intervals in a direction crossing the extension direction of the gate electrode 130 (the Y-axis direction in the drawings).

The separation structure 146 and/or the upper separation region 148 may include or be formed of any of various insulating materials. For example, the separation structure 146 or the upper separation region 148 may include or be formed of an insulating material such as silicon oxide, silicon nitride, or silicon oxynitride. However, the embodiments are not limited thereto, and a structure, a shape, a material, or so on of the separation structure 146 or the upper separation region 148 may be variously modified.

The connection region 104 and the second wiring portion 180 may be provided to connect the gate stacking structure 120 and the channel structure CH in the cell array region 102 to the circuit region 200 or the external circuit. The connection region 104 may be disposed at a periphery of the cell array region 102 and a partial portion of the second wiring portion 180 may be disposed in the connection region 104.

In an embodiment, the second wiring portion 180 may include a member that electrically connects the gate electrode 130, the channel structure CH, the horizontal conductive layers 112 and 114, and/or the second substrate 110 to the circuit region 200 or the external circuit. For example, the second wiring portion 180 may include a bit line 182, a gate contact portion 190 (which is an example of an electrode contact portion), a source contact portion 186, an input/output connection wiring 188, contact vias 180a, and a connection wiring 180b. The contact vias 180a may be connected to the bit line 182, the gate contact portion 190, the source contact portion 186, and/or the input/output connection wiring 188. For example, the contact vias 180a may contact the bit line 182, the gate contact portion 190, the source contact portion 186, and/or the input/output connection wiring 188. The connection wiring 180b may be electrically connected to the bit line 182, the gate contact portion 190, the source contact portion 186, the input/output connection wiring 188, and/or the contact vias 180a.

The bit line 182 may extend lengthwise in the direction (the Y-axis direction in the drawings) crossing the extension direction of the gate electrode 130 (the X-axis direction in the drawings). The bit line 182 may be electrically connected to the channel structures CH, for example, the channel pad 144 through the contact vias 180a, for example, a bit line contact via that passes through or penetrates the interlayer insulation layer 132.

In the connection region 104, a plurality of gate contact portions 190 may pass through or penetrate the gate stacking structure 120 to be electrically connected to the plurality of gate electrodes 130, respectively. In an embodiment, the gate stacking structure 120 may be disposed at least in the connection region 104. More particularly, the gate stacking structure 120 may be disposed in both of the cell array region 102 and the connection region 104. For example, in the connection region 104, extension lengths of the plurality of gate electrodes 130 may be substantially the same. Substantially the same may refer to have a difference within a process error (e.g., less than 10%).

As in the above, in an embodiment, a portion (e.g., a portion having a stair shape) where a partial portion of the gate stacking structure 120 is removed to electrically connect the gate electrode 130 and the gate contact portion 190 might not be included. A connection structure between the plurality of gate contact portions 190 and the plurality of gate electrodes 130 will be described in more detail.

In the connection region 104, the source contact portion 186 may pass through or penetrate a cell insulation layer 132a and be electrically connected to the horizontal conductive layers 112 and 114 and/or the second substrate 110. For example, the horizontal conductive layers 112 and 114 may contact side surfaces of the source contact portion 186, and the second substrate 110 may contact side and bottom surfaces of the source contact portion 186. In example embodiments, a lower surface of the source contact portion 186 may be lower than an upper surface of the second substrate 110. The cell insulation layer 132a may contact side surfaces of the source contact portion 186. The input/output connection wiring 188 may pass through or penetrate the gate stacking structure 120 or be disposed outside the gate stacking structure 120 to be electrically connected to the first wiring portion 280. The cell insulation layer 132a may be an insulation layer disposed on, around, and/or near the gate stacking structure 120. For example, cell insulation layer 132a may contact end surfaces of the interlayer insulation layers 132 and the gate electrodes 130, side surfaces of the source contact portion 186 and the input/output connection wiring 188, upper and side surfaces of the horizontal conductive layers 112 and 114, and an upper surfaces of the second substrate 110.

In FIG. 1, it is illustrated as an example that each of the source contact portion 186 and/or the input/output connection wiring 188 has an inclined side surface such that a width of the source contact portion 186 and/or the input/output connection wiring 188 decreases toward the second substrate 110 due to an aspect ratio and a bent portion is provided at the connection portion of the plurality of gate stacking portions 121 and 122 in a cross-sectional view. However, the embodiments are not limited thereto. In some embodiments, the source contact portion 186 and/or the input/output connection wiring 188 might not include the bent portion at the connection portion of the plurality of gate stacking portions 121 and 122. Other various modifications are possible.

For a clear understanding and simple illustration, in FIG. 1, it is illustrated as an example that the connection wiring 180b is a single layer on the same plane as the bit line 182 and an additional insulation layer 132b is at a portion other than the connection wiring 180b. However, the embodiments are not limited thereto. In some embodiments, for an electrical connection with the bit line 182, the gate contact portion 190, the source contact portion 186, and/or the input/output connection wiring 188, the connection wiring 180b may include a plurality of wiring layers and may further include a contact via.

By an electrical connection between the second wiring portion 180 and the first wiring portion 280, the bit line 182 connected to the channel structure CH, the gate electrode 130, the horizontal conductive layers 112 and 114, and/or the second substrate 110 may be electrically connected to the circuit element 220 of the circuit region 200.

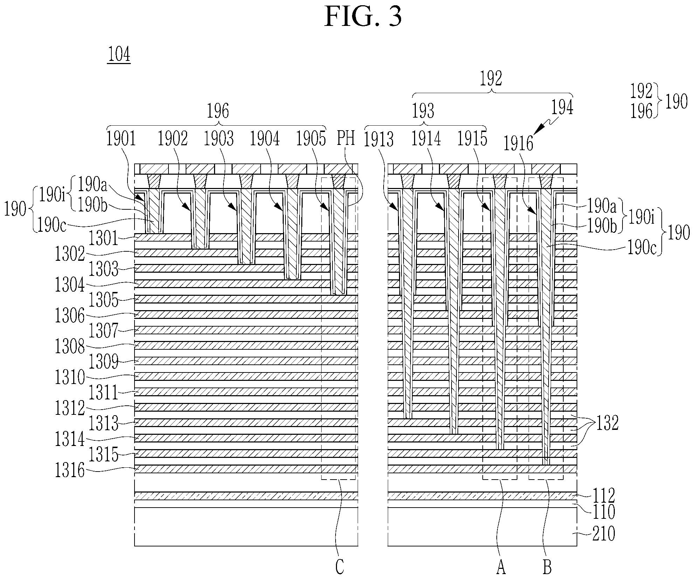

Referring to FIG. 3 to FIG. 6 together with FIG. 1, a connection structure of a plurality of gate contact portions 190 and a plurality of gate electrodes 130 will be described in detail.

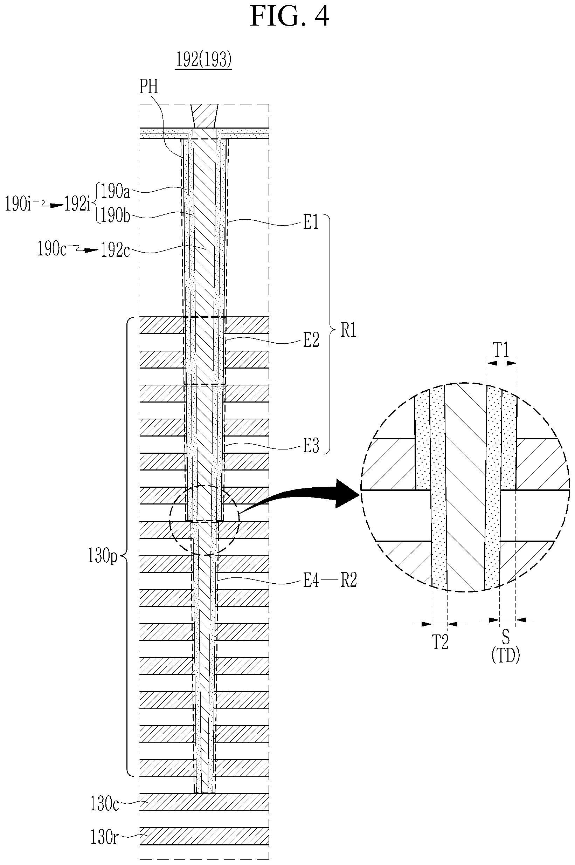

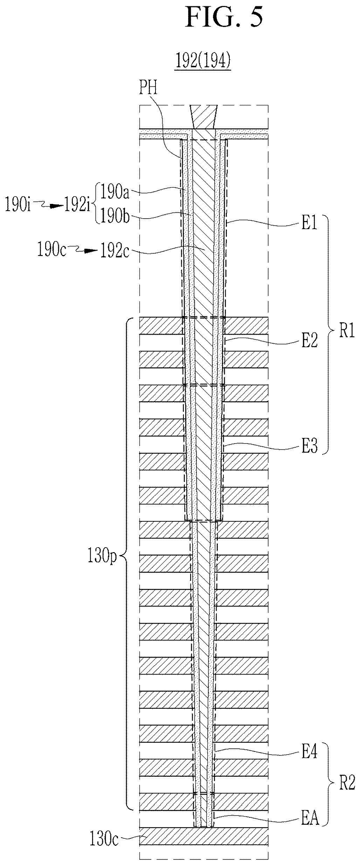

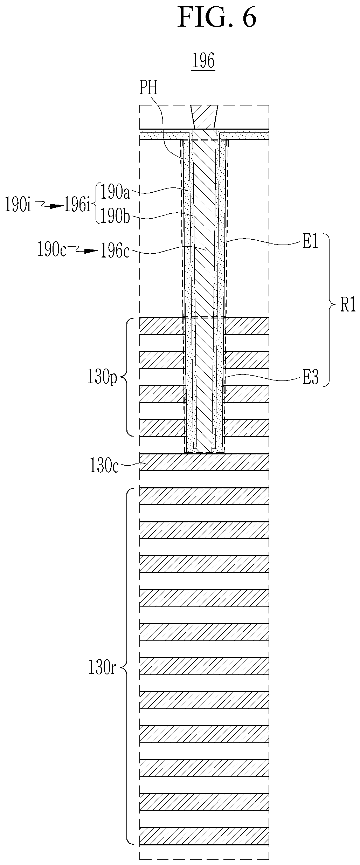

FIG. 3 is a cross-sectional view that illustrates the connection region 104 of the cell region 100 included in the semiconductor device 10 illustrated in FIG. 1. FIG. 4 is a cross-sectional view that illustrates a portion A of FIG. 3. FIG. 5 is a cross-sectional view that illustrates a portion B of FIG. 3. FIG. 6 is a cross-sectional view that illustrates a portion C of FIG. 3.

Referring to FIG. 1, and FIG. 3 to FIG. 6, in the connection region 104, a plurality of gate contact portions 190 may pass through or penetrate partial portions of the gate stacking structure 120 and may be electrically connected to (e.g., in contact with) a plurality of gate electrodes 130, respectively.

In an embodiment, each gate contact portion 190 may extend downwards from an upper surface of the gate stacking structure 120 to a lower surface of the gate stacking structure 120, and may pass through or penetrate the partial portion of the gate stacking structure 120 in the direction crossing the second substrate 110 (e.g., a vertical direction that is perpendicular to the second substrate 110 or the Z-axis direction in the drawings). The upper surface of the gate stacking structure 120 may refer to a surface adjacent to the second wiring portion 180 in the vertical direction, and the lower surface of the gate stacking structure 120 may refer to a surface opposite to the second wiring portion 180 or adjacent to the second substrate 110 in the vertical direction. Unless otherwise described, in the specification, with respect to the cell region 100, an upper portion or an upper surface may refer to a portion or a surface adjacent to the second wiring portion 180, and a lower portion or a lower surface may refer to a portion or a surface opposite to the second wiring portion 180 or adjacent to the second substrate 110.

Each gate contact portion 190 may pass through or penetrate the partial portion of the gate stacking structure 120 to have a depth to reach a connection gate electrode 130c among the plurality of gate electrodes 130. The plurality of gate contact portions 190 may be connected to the plurality of gate electrodes 130, respectively. In the vertical direction (the Z-axis direction in the drawings), the plurality of gate electrodes 130 may be disposed at different heights and the plurality of gate contact portions 190 may have different depths to reach the plurality of gate electrodes 130, respectively.

For example, a first gate contact portion 1901 may be electrically connected to a first gate electrode 1301. An n-th gate contact portion may be electrically connected to an n-th gate electrode, and a k-th gate contact portion may be electrically connected to a k-th gate electrode. The n may be a natural number greater than 1 and less than k, and the k may be a total number of the plurality of gate electrodes 130 or a total number of the plurality of gate contact portions 190.

In the drawings, it is illustrated as an example that the gate electrode 130 includes first to sixteenth gate electrodes 1301 to 1316. In this instance, first to fifth gate contact portions 1901 to 1905 may be electrically connected to first to fifth gate electrodes 1301 to 1305, respectively. Sixth to twelfth gate contact portions (not illustrated) may be electrically connected to sixth to twelfth gate electrodes 1306 to 1312, respectively. Thirteenth to sixteenth gate contact portions 1913 to 1916 may be electrically connected to thirteenth to sixteenth gate electrodes 1313 to 1316, respectively. As in the above, the plurality of gate contact portions 190 may be electrically connected to the plurality of gate electrodes 130, respectively.

For a clear understanding and simple illustration, in the drawings, it is illustrated as an example that depths of the plurality of gate contact portions 190 may sequentially increase away from the cell array region 102, but the embodiments are not limited thereto. An arrangement of the plurality of gate contact portions 190 may be variously modified.

Based on one gate contact portion 190, the plurality of gate electrodes 130 may include one connection gate electrode 130c that is electrically connected to the gate contact portion 190, and may include one or more penetrated gate electrodes 130p and/or one or more remained gate electrodes 130r. The penetrated gate electrodes 130p may be one or more gate electrodes 130 that are penetrated by the gate contact portion 190 and are electrically insulated from the gate contact portion 190 by a side insulation layer 190i of the gate contact portion 190. The penetrated gate electrodes 130p may be gate electrodes 130 that are disposed on or above the connection gate electrode 130c. The remained gate electrodes 130r may be one or more gate electrodes 130 that are not penetrated by the gate contact portion 190 and are electrically insulated from the gate contact portion 190. The remained gate electrodes 130r may be gate electrodes 130 under the connection gate electrode 130c.

In the first gate contact portion 1901, the first gate electrode 1301 may be the connection gate electrode 130c, and the gate electrodes 130 under the connection gate electrode 130c may be the remained gate electrodes 130r. Because the first gate contact portion 1901 does not have gate electrodes 130 above the connection gate electrode 130c, there are no penetrated gate electrodes 130p corresponding to the first gate contact portion 1901. In the n-th gate contact portion, the n-th gate electrode may be the connection gate electrode 130c, the one or more gate electrodes 130 on or above the connection gate electrode 130c may be the penetrated gate electrodes 130p, and the one or more gate electrodes 130 under the connection gate electrode 130c may be the remained gate electrodes 130r. In the k-th gate contact portion (the sixteenth gate contact portion 1916 in FIG. 3), the k-th gate electrode (the sixteenth gate electrode 1316 in FIG. 3) may be the connection gate electrode 130c, and the gate electrodes 130 on or above the connection gate electrode 130c may be the penetrated gate electrodes 130p. Because the k-th gate contact portion does not have gate electrodes 130 below the connection gate electrode 130c, there are no remained gate electrodes 130r corresponding to the k-th gate contact portion.

In an embodiment, each gate contact portion 190 may be electrically connected to (e.g., in contact with) an upper surface of the connection gate electrode 130c. However, the embodiments are not limited thereto. Each gate contact portion 190 may be electrically connected to (e.g., in contact with) another portion (e.g., a side surface) of the connection gate electrode 130c.

In an embodiment, each gate contact portion 190 may include a conductive portion 190c and a side insulation layer 190i. The side insulation layer 190i may be disposed between the conductive portion 190c and the gate stacking structure 120.

In each gate contact portion 190, the side insulation layer 190i may be disposed at least between a side surface of the conductive portion 190c and a side surface of the penetrated gate electrode 130p and electrically insulate the conductive portion 190c and the penetrated gate electrode 130p. The side insulation layer 190i might not be disposed on a lower surface of the conductive portion 190c and/or an upper surface of the connection gate electrode 130c. For example, the side insulation layer 190i might not disposed between the upper surface of the connection gate electrode 130c and the lower surface of the gate contact portion 190. For example, the lower surface of the side insulation layer 190i may be in contact with the connection gate electrode 130c, or may be disposed between an upper surface and a lower surface of an interlayer insulation layer 132 that is disposed on the connection gate electrode 130c.

Thereby, the side insulation layer 190i may surround an entire portion of the side surface of the gate contact portion 190 that corresponds to the penetrated gate electrode 130p, and stably insulate between the gate contact portion 190 and the penetrated gate electrode 130p. However, the embodiments are not limited thereto, and a position of the side insulation layer 190i, a connection position of the gate contact portion 190 and the connection gate electrode 130c, or so on may be variously modified.

For example, the conductive portion 190c may have a pillar shape (e.g., a pillar shape that has a planar shape of a circular or polygonal shape). The side insulation layer 190i may have a planar shape of an annular shape, a ring shape, a frame shape, or so on that surrounds the conductive portion 190c.

In the drawings, it is illustrated as an example that, in a cross-sectional view, the gate contact portion 190 or the conductive portion 190c may have an inclined side surface such that a width of the gate contact portion 190 or the conductive portion 190c decreases toward the second substrate 110 due to a high aspect ratio. However, the embodiments are not limited thereto, and a shape, a structure, or so on of the gate contact portion 190 or the conductive portion 190c may be variously modified.

In an embodiment, the gate contact portion 190 inside a through hole PH may be electrically connected to an upper portion of the connection gate electrode 130c. For example, a plurality of through holes PH may be included. Each of the plurality of through holes PH may pass through or penetrate the gate stacking structure 120, and the plurality of through holes PH may be spaced apart from each other interposing the gate stacking structure 120. One gate contact portion 190 may be disposed in one through hole PH. A lower surface of the conductive portion 190c of one gate contact portion 190 in one through hole PH may be electrically connected to (e.g., in contact with) the upper surface of the connection gate electrode 130c. For example, the plurality of gate contact portions 190 may be disposed in the plurality of through holes PH, respectively, that are spaced apart from each other so that the plurality of gate contact portions 190 and the plurality of through holes PH correspond one-to-one. In an embodiment, the through hole PH may have any of various planar shapes such as a circular shape, a polygonal shape, an elliptical shape, or so on, and the embodiments are not limited to a planar shape of the through hole PH.

Accordingly, a pad region (e.g., a pad insulation layer) through which a plurality of gate contact portions 190 pass together, an additional insulation layer (e.g., the pad insulation layer) that is disposed between the plurality of gate contact portions 190 other than the interlayer insulation layer 132, or a portion (e.g., a portion having a stair shape) in which a partial portion of the gate stacking structure 120 is removed for an electrical connection of the gate contact portion 190 may be omitted. For example, without the pad region or the pad insulation layer, the plurality of gate contact portions 190 may be electrically connected to the plurality of gate electrodes 130, respectively and individually. Accordingly, a process of electrically connecting the gate contact portion 190 and the gate electrode 130 may be simplified and an area of the connection region 104 may be reduced.

On the other hand, in a comparative example that includes pad regions, a process of etching a partial portion of a gate stacking structure (e.g., a process of forming a portion having a stair shape), a process of forming a pad insulation layer that covers the portion having the stair shape of the gate stacking structure, and a process of electrically connecting a plurality of gate contact portions that pass through or penetrate one pad insulation layer together to a plurality of gate electrodes, respectively, are performed. Accordingly, a process of forming the pad region and a process of forming the gate contact portions may be complicated. In the pad region or the pad insulation layer through which the plurality of gate contact portions pass together, a width between the plurality of gate contact portions needs to be secured to prevent a mis-alignment. Accordingly, an area of a connection region may increase.

In an embodiment, the plurality of gate contact portions 190 may include a first contact portion 192 and a second contact portion 196. The side insulation layer 190i of the first contact portion 192 and the side insulation layer 190i of the second contact portion 196 may have different shapes or structures. More particularly, the first contact portion 192 may include a first conductive portion 192c, and a first side insulation layer 192i disposed between the gate stacking structure 120 and the first conductive portion 192c. The second contact portion 196 may include a second conductive portion 196c, and a second side insulation layer 196i disposed between the gate stacking structure 120 and the second conductive portion 196c. The second side insulation layer 196i may have a different shape or structure from the first side insulation layer 192i.

As illustrated in FIG. 4 and FIG. 5, the first conductive portion 192c of the first contact portion 192 may include or be formed of a conductive material, and may fill at least a partial portion of the through hole PH in a portion other than the first side insulation layer 192i. For example, the first conductive portion 192c may include or be formed of tungsten (W), copper (Cu), aluminum (Al), or so on, or may further include a diffusion barrier layer. However, the embodiments are not limited to a material of the first conductive portion 192c.

The first side insulation layer 192i of the first contact portion 192 may include a first portion R1, and a second portion R2 that has a thickness smaller than a thickness of the first portion R1. A thickness T1 of the first portion R1 or a thickness T2 of the second portion R2 may be measured in a direction perpendicular to a side surface of the first side insulation layer 192i. For example, the thickness T1 of the first portion R1 and the thickness T2 of the second portion R2 may be measured in a direction parallel to an upper surface of the second substrate 110. The thickness T1 of the first portion R1 may refer to an average thickness of the first portion R1 or a thickness of a portion of the first portion R1 that is adjacent to the second portion R2. The thickness T2 of the second portion R2 may refer to an average thickness of the second portion R2 or a thickness of a portion of the second portion R2 that is adjacent to the first portion R1.

In the vertical direction (the Z-axis direction in the drawings), the first portion R1 may be disposed at an upper portion of the first contact portion 192, and may be spaced apart from a lower surface of the first contact portion 192. For example, an upper surface of the first portion R1 may be disposed to be adjacent to the upper surface of the first contact portion 192. For example, the upper surface of the first portion R1 may be disposed at a same plane as the upper surface of the first contact portion 192. The lower surface of the first portion R1 may be spaced apart from the lower surface of the first contact portion 192. The lower surface of the first portion R1 may be spaced apart from the lower surface of the first contact portion 192 while interposing a portion corresponding to at least one penetrated gate electrode 130p (e.g., a plurality of penetrated gate electrodes 130p).

In the vertical direction (the Z-axis direction in the drawings), the second portion R2 may be disposed at a lower portion of the first portion R1 or under the first portion R1. The second portion R2 may include a portion that corresponds to one or more of the plurality of gate electrodes 130.

In an embodiment, the first side insulation layer 192i may include a first layer 190a and a second layer 190b. The first layer 190a may be disposed in the first portion R1, and the second layer 190b may be disposed in the first portion R1 and the second portion R2 on an inner side surface of the first layer 190a.

More particularly, the first layer 190a may be disposed on (e.g., in contact with) the side surface of the gate stacking structure 120 in the first portion R1. The second layer 190b may be disposed on (e.g., in contact with) an inner side surface of the first layer 190a in the first portion R1, and may be disposed on (e.g., in contact with) the side surface of the gate stacking structure 120 in the second portion R2. However, the embodiments are not limited thereto. In some embodiments, an additional layer may be disposed between adjacent two portions among the gate stacking structure 120, the first layer 190a, and the second layer 190b.

An inner side surface of the first side insulation layer 192i (e.g., the second layer 190b) may be in contact with an outer side surface of the first conductive portion 192c. However, the embodiments are not limited thereto, and an additional layer may be disposed between the inner side surface of the first side insulation layer 192i (e.g., the second layer 190b) and the outer side surface of the first conductive portion 192c.

As in the above, the first layer 190a and the second layer 190b may be disposed together in the first portion R1, and the second layer 190b may be disposed alone without the first layer 190a in the second portion R2. For example, the first portion R1 and the second portion R2 may have different stacking structures, and the first portion R1 and the second portion R2 may have different thicknesses.

The inner side surface of the first side insulation layer 192i (e.g., the second layer 190b) may have an inclined surface that is inclined to the vertical direction of the semiconductor device 10 (the Z-axis direction in the drawings) without a stepped portion or a bent portion. The outer side surface of the first side insulation layer 192i (e.g., the first layer 190a and the second layer 190b) may have an inclined surface that is inclined to the vertical direction, and a step S may be disposed between the first portion R1 and the second portion R2. However, the embodiments are not limited thereto. In some embodiments, the inner side surface of the first side insulation layer 192i (e.g., the second layer 190b) may have a vertical surface that is parallel to the vertical direction of the semiconductor device 10 (the Z-axis direction in the drawings) without a stepped portion or a bent portion. The outer side surface of the first side insulation layer 192i (e.g., the first layer 190a and the second layer 190b) may have a vertical surface parallel to the vertical direction, and a step S may be disposed between the first portion R1 and the second portion R2.

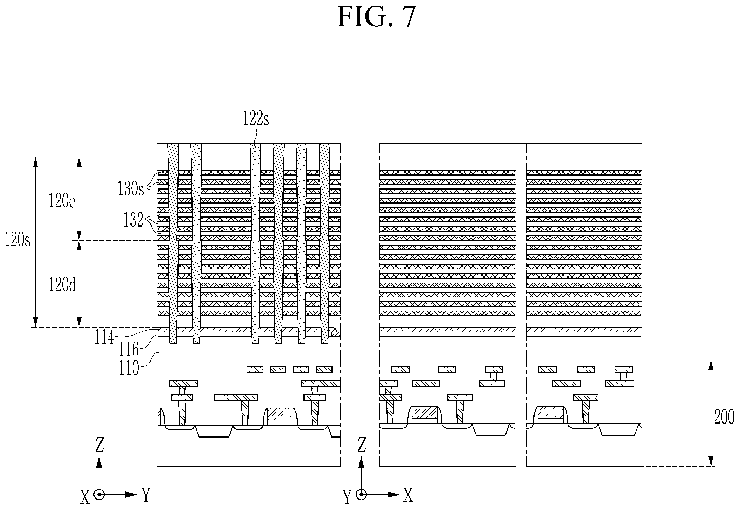

The first layer 190a may be an insulation layer configured to protect a stacking structure 120s (refer to FIG. 7) for the gate stacking structure 120 in a succeeding partial etching process (e.g., a fourth partial etching process E4). For example, the first layer 190a may be an insulation layer configured to protect the stacking structure 120s in the succeeding partial etching process using a hard mask. The first layer 190a may be referred to as a protective layer, a cover layer, a liner layer, a first insulation layer, or so on. By protecting the stacking structure 120s using the first layer 190a, a depth of the through hole PH formed in the succeeding partial etching process may increase, and time and cost of a process of forming the through hole PH may be reduced. This will be described in more detail in a manufacturing method of a semiconductor device 10.

The second layer 190b may be an insulation layer formed on the plurality of through holes PH to electrically insulate the penetrated gate electrode 130p and the first conductive portion 192c after performing the process of forming the plurality of through holes PH. The second layer 190b may be referred to as an electrical insulation layer, a second insulation layer, or so on.

When the first layer 190a and the second layer 190b may include different materials, a boundary between the first layer 190a and the second layer 190b may be seen or confirmed. Even when the first layer 190a and the second layer 190b include the same material, the boundary between the first layer 190a and the second layer 190b may be seen or confirmed by a manufacturing process. For example, when the first layer 190a and the second layer 190b are formed by different processes and have different compositions or properties or when a property of the inner side surface of the first layer 190a varies as time passes between a process of forming the first layer 190a and a process of forming the second layer 190b, the boundary between the first layer 190a and the second layer 190b may be seen or confirmed. When the first layer 190a and the second layer 190b include the same material and there may be difficulty to confirm the boundary between the first layer 190a and the second layer 190b, positions of the first layer 190a and the second layer 190b may be judged or expected by a difference in thickness of the first portion R1 and the second portion R2 or the step S between the first portion R1 and the second portion R2.

For example, a distance between an inner side surface of a gate electrode 130 that corresponds to the first portion R1 and the first conductive portion 192c may be greater than a distance between an inner side surface of another gate electrode 130 that corresponds to the second portion R2 and the first conductive portion 192c. The distance between the inner side surface of the gate electrode 130 and the first conductive portion 192c may be a distance between the inner side surface of the gate electrode 130 adjacent to the first conductive portion 192c and the outer side surface of the first conductive portion 192c in the extension direction of the gate electrode 130. In a case that a plurality of gate electrodes 130 correspond to the first portion R1 and a plurality of gate electrodes 130 correspond to the second portion R2, the plurality of gate electrodes 130 that correspond to the first portion R1 may have inclined inner side surfaces that are parallel to the inclined outer side surface of the first conductive portion 192c, and the plurality of gate electrodes 130 that correspond to the second portion R2 may have inclined inner side surfaces that are parallel to the inclined outer side surface of the first conductive portion 192c. The plurality of gate electrodes 130 that correspond to the first portion R1 and the plurality of gate electrodes 130 that correspond to the second portion R2 may be spaced apart from each other by the step S.

In an embodiment, the first layer 190a and/or the second layer 190b may include any of various insulating materials. For example, the first layer 190a and the second layer 190b may include the same material, or the first layer 190a and the second layer 190b may include different materials from each other.

For example, the first layer 190a may include or be formed of oxide (e.g., silicon oxide), oxynitride (e.g., silicon oxynitride), a low dielectric constant material having a lower dielectric constant than silicon oxide, or a combination thereof. The first layer 190a may include a single layer or a plurality of layers. For example, the second layer 190b may include or be formed of oxide (e.g., silicon oxide), nitride (e.g., silicon nitride), oxynitride (e.g., silicon oxynitride), a low dielectric constant material having a lower dielectric constant than silicon oxide, or a combination thereof. The second layer 190b may include a single layer or a plurality of layers.

In an embodiment, in the direction perpendicular to the side surface of the first side insulation layer 192i, a difference TD between the thickness T1 of the first portion R1 and the thickness T2 of the second portion R2, a height of the step S, or a thickness of the first layer 190a may be 0.5nm or more (e.g., 1nm or more). Thereby, the first layer 190a may have a thickness of 0.5nm or more (e.g., 1nm or more) to stably protect the stacking structure 120s. Herein, the height of the step S may be the distance in the horizontal direction (e.g., a direction parallel to an upper surface of the second substrate 110) between the outer surface of the second layer 190b and the outer surface of the first layer 190a.

For example, in the direction perpendicular to the side surface of the first side insulation layer 192i, the difference TD between the thickness T1 of the first portion R1 and the thickness T2 of the second portion R2, the height of the step S, or the thickness of the first layer 190a may be 20nm or less (e.g., 10nm or less, for example, 5nm or less). As in the above, the thickness of the first layer 190a may be reduced and an area or a volume of the first conductive portion 192c may be sufficiently secured.

However, the embodiments are not limited thereto, and the thickness of the first layer 190a may be less than 0.5nm (e.g., 1nm), or greater than 20nm (e.g., 10nm, as an example, 5nm).

In an embodiment, in the direction perpendicular to the side surface of the first side insulation layer 192i, a ratio (T2/T1) of the thickness T2 of the second portion R2 to the thickness T1 of the first portion R1 may be in a range from 0.5 to 1. In some embodiments, in the direction perpendicular to the side surface of the first side insulation layer 192i, the difference TD between the thickness T1 of the first portion R1 and the thickness T2 of the second portion R2, the height of the step S, or the thickness of the first layer 190a may be the same or less than the thickness T2 of the second portion R2 or a thickness of the second layer 190b. The first layer 190a may have a relatively small thickness configured to protect the stacking structure 120s in the succeeding partial etching process, and the second layer 190b may have a relatively large thickness to enhance an electrical insulation property between the gate stacking structure 120 and the first conductive portion 192c. However, the embodiments are not limited thereto. In some embodiments, in the direction perpendicular to the side surface of the first side insulation layer 192i, the ratio (T2/T1) of the thickness T2 of the second portion R2 to the thickness T1 of the first portion R1 may be less than 0.5. In some embodiments, the difference TD between the thickness T1 of the first portion R1 and the thickness T2 of the second portion R2, the height of the step S, or the thickness of the first layer 190a may be greater than the thickness T2 of the second portion R2 or the thickness of the second layer 190b.

In an embodiment, the difference TD between the thickness T1 of the first portion R1 and the thickness T2 of the second portion R2, the height of the step S, or the thickness of the first layer 190a in the direction perpendicular to the side surface of the first side insulation layer 192i may be less than a thickness of the interlayer insulation layer 132 or a thickness of the gate electrode 130 in the vertical direction (the Z-axis direction in the drawings). The first layer 190a may have a relatively small thickness configured to protect the stacking structure 120s in the succeeding partial etching process. However, the embodiments are not limited thereto. In some embodiments, the difference TD between the thickness T1 of the first portion R1 and the thickness T2 of the second portion R2, the height of the step S, or the thickness of the first layer 190a may be the same or greater than the thickness of the interlayer insulation layer 132 or the thickness of the gate electrode 130.

However, the embodiments are not limited thereto, and the difference TD between the thickness T1 of the first portion R1 and the thickness T2 of the second portion R2, the height of the step S, the thickness of the first layer 190a, the thickness of the second layer 190b, or so on may be variously modified.

For a clear understanding, in the drawings, it is illustrated as an example that the first layer 190a and the second layer 190b include portions sequentially disposed on the upper surface of the gate stacking structure 120. Further, boundaries between the upper surface of the gate stacking structure 120, and the portions of the first layer 190a and the second layer 190b on the upper surface of the gate stacking structure 120 are illustrated. However, the embodiments are not limited thereto. In some embodiments, the portion of the first layer 190a and/or the portion of the second layer 190b on the upper surface of the gate stacking structure 120 may be removed. In some embodiments, the boundary of the portion of the first layer 190a and/or the portion of the second layer 190b on the upper surface of the gate stacking structure 120 might not be seen or confirmed in a final structure.

As illustrated in FIG. 6, the second conductive portion 196c of the second contact portion 196 may include or be formed of a conductive material and may fill at least a partial portion of the through hole PH in a portion other than the second side insulation layer 196i. For example, the second conductive portion 196c may include or be formed of tungsten (W), copper (Cu), aluminum (Al), or so on, or further include a diffusion barrier layer. The second conductive portion 196c may include or be formed of a conductive material the same as a material of the first conductive portion 192c, or the second conductive portion 196c may be formed together by a same process as the first conductive portion 192c. However, the embodiments are not limited thereto. In some embodiments, the second conductive portion 196c may include or be formed of a conductive material different from a material of the first conductive portion 192c, or the second conductive portion 196c may be formed by a different process from the first conductive portion 192c. As in the above, the embodiments are not limited to a material of the second conductive portion 196c.

The second side insulation layer 196i of the second contact portion 196 may have a different shape or structure from the first side insulation layer 192i. For example, the second side insulation layer 196i might not include a layer that is included in the first side insulation layer 192i, the second side insulation layer 196i may include a layer that is not included in the first side insulation layer 192i, or shapes, arrangements, relative positions, or so on of layers (e.g., the first layers 190a and/or the second layers 190b) that included in the first side insulation layer 192i and the second side insulation layer 196i may be different from each other.

For example, the second side insulation layer 196i may include a portion that corresponds to the first portion R1 of the first side insulation layer 192i (e.g., a portion having a material, a structure, or a thickness the same as a material, a structure, or a thickness of the first portion R1) in an entire portion, but might not include a portion that corresponds to the second portion R2. For example, in the first side insulation layer 192i and the second side insulation layer 196i, arrangements or relative positions of the first layer 190a and the second layer 190b may be different from each other.

In an embodiment, in the second side insulation layer 196i, the first layer 190a and the second layer 190b may entirely and continuously extend from an upper surface of the second contact portion 196 to a lower surface of the second contact portion 196. For example, in the second side insulation layer 196i, a portion that includes the first layer 190a and the second layer 190b (i.e., a portion that corresponds to the first portion R1) may be entirely disposed from the upper surface of the second contact portion 196 to the lower surface of the second contact portion 196.

More particularly, in the second side insulation layer 196i, the first layer 190a may be disposed on the side surface of the gate stacking structure 120, and the second layer 190b may be disposed on the inner side surface of the first layer 190a. For example, the second side insulation layer 196i might not include a portion of the second layer 190b that is in contact with the side surface of the gate stacking structure 120. For example, in the second side insulation layer 196i, the first layer 190a may be in contact with the side surface of the gate stacking structure 120, and the second layer 190b may be in contact with the first layer 190a. However, the embodiments are not limited thereto. In some embodiments, in the second side insulation layer 196i, an additional layer may be disposed between the first layer 190a and the side surface of the gate stacking structure 120, or an additional layer may be disposed between the second layer 190b and the first layer 190a.

An inner side surface of the second side insulation layer 196i (e.g., the second layer 190b) may be in contact with an outer side surface of the second conductive portion 196c. However, the embodiments are not limited thereto, and an additional layer may be disposed between the inner side surface of the second side insulation layer 196i (e.g., the second layer 190b) and the outer side surface of the second conductive portion 196c.

As in the above, the first layer 190a and the second layer 190b may be disposed together in an entire portion of the second side insulation layer 196i, and the entire portion of the second side insulation layer 196i may have the same stacking structure. Accordingly, the entire portion of the second side insulation layer 196i may have substantially the same thickness. The "substantially the same thickness" may include thicknesses having a difference due to a process error (for example, a thickness difference of less than 10% or a thickness difference of less than 0.5 nm). However, the embodiments are not limited thereto.

An inner side surface of the second side insulation layer 196i (e.g., the second layer 190b) may have an inclined surface that is inclined to the vertical direction of the semiconductor device 10 (the Z-axis direction in the drawings) without a stepped portion or a bent portion. An outer surface of the second side insulation layer 196i (e.g., the first layer 190a) may have an inclined surface that is inclined to the vertical direction without a stepped portion or a bent portion. However, the embodiments are not limited thereto. In some embodiments, the inner side surface of the second side insulation layer 196i (e.g., the second layer 190b) may have a vertical surface that is parallel to the vertical direction of the semiconductor device 10 (the Z-axis direction in the drawings) without a stepped portion or a bent portion. An outer side surface of the second side insulation layer 196i (e.g., the first layer 190a) may include a vertical surface that is parallel to the vertical direction.

In an embodiment, the first contact portion 192 may include a plurality of first contact portions 192 having different depths, and the second contact portion 196 may include a plurality of second contact portions 196 having different depths. The plurality of first contact portions 192 may include a first base contact portion 193, and further include the first additional contact portion 194.

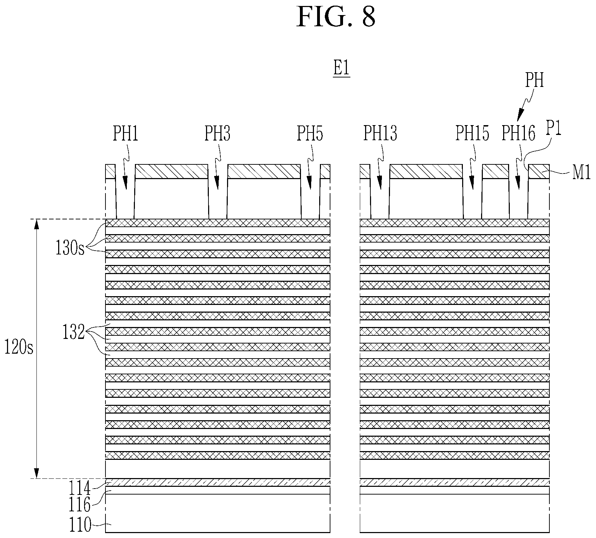

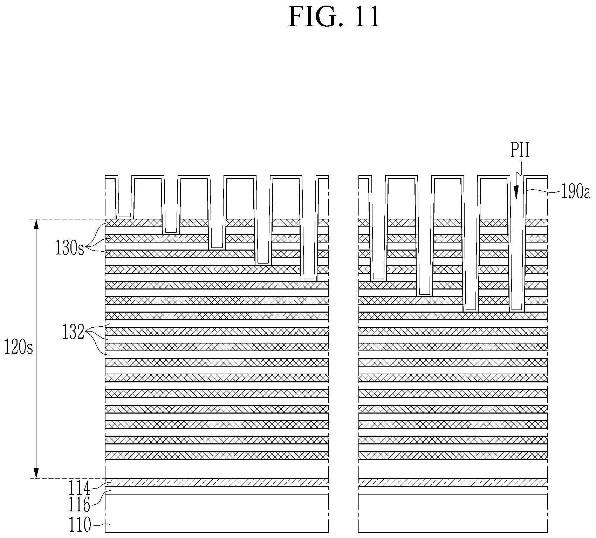

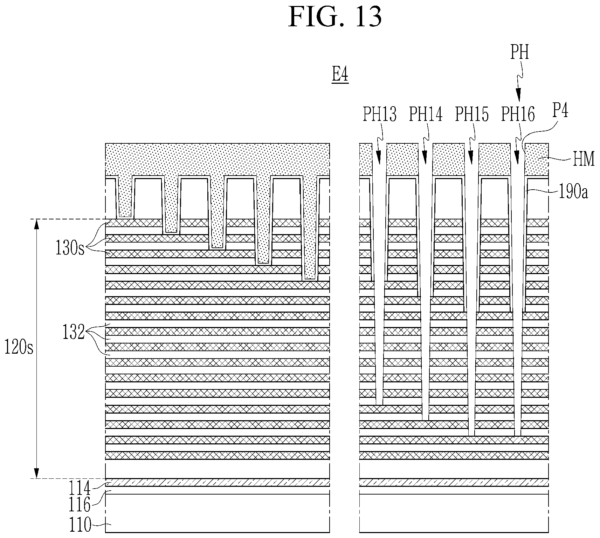

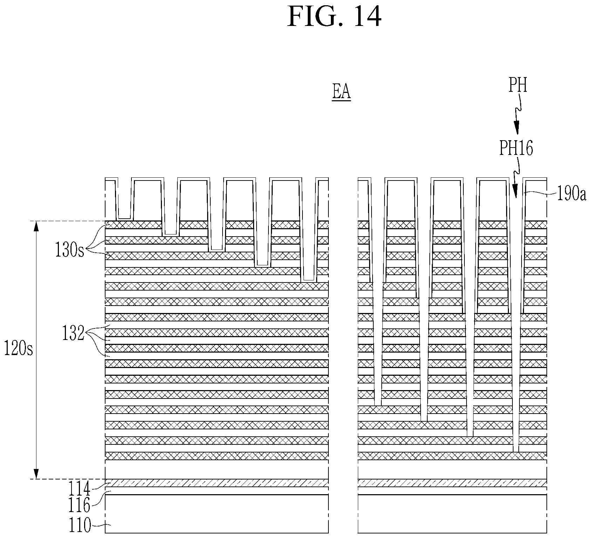

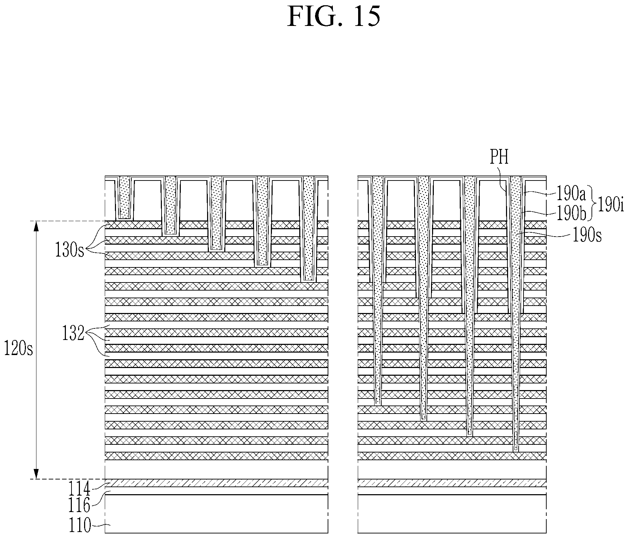

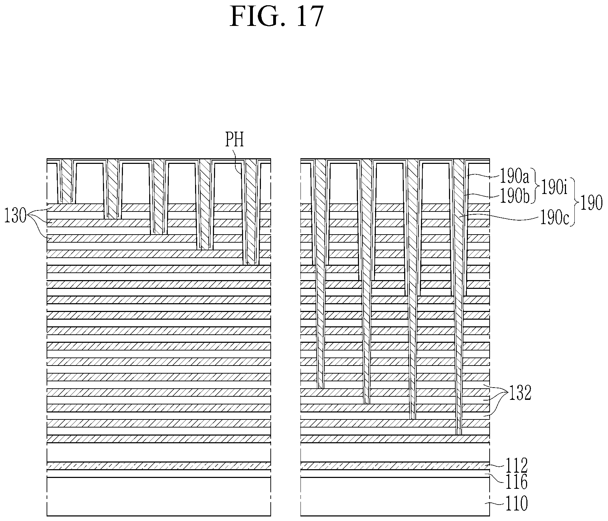

A process of forming the plurality of gate contact portions 190 (e.g., the plurality of first contact portions 192 and the plurality of second contact portions 196) may include a preceding partial etching process (refer to FIG. 8 to FIG. 10), a process of forming the first layer 190a (refer to FIG. 11), a succeeding partial etching process (refer to FIG. 13) and/or an additional etching process EA (refer to FIG. 14), a process of forming the second layer 190b (refer to FIG. 15), and a process of include the conductive portion 190c (refer to FIG. 17). The preceding partial etching process may be performed before the process of forming the first layer 190a. The succeeding partial etching process (refer to FIG. 13) and/or the additional etching process EA (refer to FIG. 14) may be performed after the process of forming the first layer 190a.

In a plurality of partial etching processes (the preceding partial etching process and the succeeding partial etching process), the through hole PH may be formed according to binary system by etching the interlayer insulation layer 132 and a layer (e.g., a sacrificial insulation layer 130s (refer to FIG. 7)) on the interlayer insulation layer 132. For example, in the preceding partial etching process and/or the succeeding partial etching process, the interlayer insulation layer 132 or the interlayer insulation layers 132 of 1, 2, 4,..., 2^{(m-1)} and the sacrificial insulation layer 130s or the sacrificial insulation layers 130s thereon may be etched. The m may be a natural number greater than 1, and be a total number of the partial etching processes. The m-th partial etching process may be a longest partial etching process of etching the longest depth. An etching depth of the m-th partial etching process may be greater than an etching depth of another partial etching process and the additional etching process EA.

For example, in a first partial etching process E1, one (that is, 2⁰) interlayer insulation layer 132 may be etched. In an n-th partial etching process, 2⁽ⁿ⁻¹⁾ interlayer insulation layers 132 and the sacrificial insulation layer 130s or the sacrificial insulation layers 130s thereon may be etched.

As in the above, the partial etching processes according to the binary system are repeatedly performed, a plurality of through holes PH having different depths may be formed by a small number of etching processes. For example, when the partial etching process according to the binary system is repeated four times, fifteen through holes PH having different depths may be formed. For example, when the partial etching process according to the binary system is repeated five times, thirty-one through holes PH having different depths may be formed. For example, when the partial etching process according to the binary system is repeated six times, sixth-three through holes PH having different depths may be formed. Thereby, a number of etching processes may be effectively reduced.

As in the above, for a clear understanding and simple illustration, in the drawings, it is illustrated as an example that sixteen gate electrodes 130 are included. In this instance, sixteen through holes PH that correspond to sixteen gate contact portions 190 may be formed by four partial etching processes (i.e., first to fourth partial etching processes E1, E2, E3, and E4) and one additional etching process EA. Hereinafter, it is illustrated or described as an example that first to third partial etching processes E1, E2, and E3 are the preceding partial etching processes, and the fourth partial etching process E4 is the succeeding partial etching process. However, the embodiments are not limited thereto. Therefore, a number of the gate electrodes 130 may be variously modified, a number of the plurality of partial etching processes, and/or a number of the additional etching process EA may be variously modified, or a number of the preceding partial etching processes and/or a number of the succeeding partial etching process may be variously modified.

A process of forming the first contact portion 192 may include the preceding partial etching process, the process of forming the first layer 190a, the succeeding partial etching process and/or the additional etching process EA, the process of forming the second layer 190b, and the process of forming the conductive portion 190c.

The process of forming the first base contact portion 193 among the first contact portions 192 may include the preceding partial etching process, the process of forming the first layer 190a, the succeeding partial etching process, the process of forming the second layer 190b, and the process of forming the conductive portion 190c. For example, referring to FIG. 3 and FIG. 4, to form a fifteenth gate contact portion 1915 of the first base contact portion 193, first to third partial etching processes E1, E2, and E3 of the preceding partial etching processes may be performed, the first layer 190a may be formed on an inner side surface of a portion formed by the first to third partial etching processes E1, E2, and E3, a fourth partial etching process E4 of the succeeding partial etching process may be performed, and the second layer 190b and the conductive portion 190c may be formed. Thereby, the first portion R1 where the first layer 190a and the second layer 190b are disposed together may be disposed in a portion formed by the first to third partial etching processes E1, E2, and E3, and the second portion R2 where the second layer 190b is disposed may be disposed in a portion formed by the fourth partial etching process E4.

A process of forming the first additional contact portion 194 among the first contact portions 192 may include the preceding partial etching process, the process of forming the first layer 190a, the succeeding partial etching process, the additional etching process EA, the process of forming the second layer 190b, and the process of forming the conductive portion 190c. For example, referring to FIG. 3 and FIG. 5, to form a sixteenth gate contact portion 1916 of the first additional contact portion 194, the first to third partial etching processes E1, E2, and E3 of the preceding partial etching processes may be performed, the first layer 190a may be formed on an inner side surface of a portion formed by the first to third partial etching processes E1, E2, and E3, the fourth partial etching process E4 of the succeeding partial etching process and the additional etching process EA may be performed, and the second layer 190b and the conductive portion 190c may be formed. Thereby, the first portion R1 where the first layer 190a and the second layer 190b are disposed together may be disposed in a portion formed by the first to third partial etching processes E1, E2, and E3, and the second portion R2 where the second layer 190b is disposed may be disposed in a portion formed by the fourth partial etching process E4 and the additional etching process EA.

A process of forming the second contact portion 196 may include the preceding partial etching process, the process of forming the first layer 190a, the process of forming the second layer 190b, and the process of forming the conductive portion 190c. For example, the process of forming the second contact portion 196 might not include the succeeding partial etching process and/or the additional etching process EA. For example, referring to FIG. 3 and FIG. 6, to form a fifth gate contact portion 1905 of the second contact portion 196, the first and third partial etching processes E1 and E3 of the preceding partial etching processes may be performed, the first layer 190a may be formed on an inner side surface of a portion formed by the first and third partial etching processes E1 and E3, and the second layer 190b and the conductive portion 190c may be formed. Thereby, in an entire portion formed by the first and third partial etching process E1 and E3, the first layer 190a and the second layer 190b may be disposed together. Accordingly, a portion where the second layer 190b is disposed without the first layer 190a (e.g., a portion that correspond to the second portion R2 of the first side insulation layer 192i) might be not included.

In an embodiment, a depth of each of the plurality of first contact portions 192 may be greater than a depth of each of the plurality of second contact portions 196. This may be because the first contact portion 192 may be formed by additionally performing the succeeding partial etching process and/or the additional etching process EA, compared to the second contact portion 196, as in the above.

In an embodiment, a number of the first contact portions 192 may be greater than a number of the second contact portions 196. A total number of the through holes PH of different depths formed by a process from the first partial etching process E1 to the n-th partial etching process may be a sum of 1, 2, 4,..., 2⁽ⁿ⁻¹⁾, that is, may be {2⁽ⁿ⁻¹⁾-1}. A total number of the through holes PH of different depths formed by an (n+1)-th partial etching process may be 2ⁿ. For example, the total number of the through holes PH of different depths formed by the (n+1)-th partial etching process may be greater than the total number of the through holes PH of different depths formed by the process from the first partial etching process E1 to the n-th partial etching process. For example, a total number of the through holes PH having different depths formed by the first to third partial etching processes E1, E2, and E3 may be seven, and a total number of the through holes PH having different depths formed by the fourth partial etching process E4 may be eight. Further, the first contact portion 192 may further include the first additional contact portion 194 formed by the additional etching process EA.

However, the embodiments are not limited thereto. According to an order or so on of the plurality of partial etching processes according to the binary system and/or the additional etching process EA, the number of the first contact portions 192 may be the same as or less than the number of the second contact portions 196.

In an embodiment, in each first contact portion 192, a number of the gate electrodes 130 that correspond to the second portion R2 (e.g., the connection gate electrode 130c and/or the remained gate electrode 130r) may be greater than a number of the gate electrodes 130 that correspond to the first portion R1 (e.g., the penetrated gate electrode 130p). A number of the interlayer insulation layers 132 etched by the process from the first partial etching process E1 to the n-th partial etching process may be a sum of 1, 2, 4,..., 2⁽ⁿ⁻¹⁾, that is, may be {2⁽ⁿ⁻¹⁾-1}. A number of the interlayer insulation layers 132 etched by the (n+1)-th partial etching process may be 2ⁿ. For example, the number of the interlayer insulation layers 132 etched by the (n+1)-th partial etching process may be greater than the number of the interlayer insulation layers 132 etched by the process from the first partial etching process E1 to the n-th partial etching process. Accordingly, a number of the gate electrodes 130 in a portion that corresponds to the (n+1)-th partial etching process may be greater than a number of the gate electrodes 130 in a portion that corresponds to the process from the first partial etching process E1 to the n-th partial etching process. For example, a total number of the interlayer insulation layers 132 etched by the first to third partial etching processes E1, E2, and E3 may be seven, and a total number of the gate electrodes 130 thereon may be six. For example, a total number of the interlayer insulation layers 132 etched by the fourth partial etching process E4 may be eight, and a total number of the gate electrodes 130 thereon may be seven or eight.

Accordingly, a number of the gate electrodes 130 that correspond to the second portion R2 formed by the succeeding partial etching process may be greater than a number of the gate electrodes 130 that correspond to the first portion R1. Further, the second portion R2 may further include a portion by the additional etching process EA.

However, the embodiments are not limited thereto. According to an order or so on of the plurality of partial etching processes according to the binary system and/or the additional etching process EA, the number of the gate electrodes 130 that correspond to the second portion R2 formed by the succeeding partial etching process may be the same as or smaller than the number of the gate electrodes 130 that correspond to the first portion R1.

In an embodiment, the succeeding partial etching process performed after the process of forming the first layer 190a may include the m-th partial etching process of the longest partial etching process. For example, when the partial etching process may include the first to fourth partial etching processes E1, E2, E3, and E4, the succeeding partial etching process may include the fourth partial etching process E4. Thereby, in the longest partial etching process of etching the longest depth, the first layer 190a may stably protect the stacking structure 120s for the gate stacking structure 120.

However, the embodiments are not limited thereto. Therefore, the succeeding partial etching process may include a plurality of partial etching processes, or an order or so on of the plurality of partial etching processes according to the binary system may be varied. Other various modifications are possible.

According to an embodiment, the plurality of through holes PH for the plurality of gate contact portions 190 may be formed using the partial etching processes according to the binary system, and the process of forming the gate contact portions 190 may be simplified and an area of the connection region 104 may be reduced. The first layer 190a may be formed before the succeeding partial etching process, and damage to the stacking structure 120s that may be induced in the succeeding partial etching process may be prevented and the through hole PH that has a relatively large depth may be stably formed. Thereby, reliability and productivity of the semiconductor device 10 may be enhanced.

Particularly, when a number of the gate electrodes 130 that are included in the gate stacking structure 120 increases to increase a memory capacity, a number of the gate contact portions 190 may increase and the gate contact portion 190 may have a relatively high aspect ratio. In this instance, according to an embodiment, the area of the connection region 104 may be effectively reduced and the through hole PH that has a relatively high aspect ratio may be stably formed.

Hereinafter, referring to FIG. 7 to FIG. 18, a manufacturing method of a semiconductor device according to an embodiment will be described in more detail. To the extent that an element is not described in detail below, it may be understood that the element is substantially the same as a corresponding element that has been described elsewhere within the present disclosure. A portion which is not described in the above will be described in detail.

FIG. 7 to FIG. 18 are cross-sectional views that illustrate an example manufacturing method of a semiconductor device. In FIG. 7, FIG. 16, FIG. 18, a cell array region 102 and a connection region 104 are illustrated together to correspond to a partial portion of FIG. 1. In FIG. 8 to FIG. 15, and FIG. 17, the connection region 104 is illustrated to correspond to FIG. 3. Hereinafter, in a manufacturing method of a semiconductor device 10, a gate stacking structure 120, a channel structure CH, a separation structure 146, and a gate contact portion 190 are mainly described.

As illustrated in FIG. 7, a second substrate 110 and a stacking structure 120s may be formed on a circuit region 200, and a channel sacrificial layer 122s that extends to pass through or penetrate the stacking structure 120s may be formed. After a horizontal insulation layer 116 and a second horizontal conductive layer 114 are formed on the second substrate 110, the stacking structure 120s may be formed. The channel sacrificial layer 122s may pass through or penetrate the stacking structure 120s, the horizontal insulation layer 116, and the second horizontal conductive layer 114.

More particularly, the second substrate 110 may be formed on the circuit region 200, and the horizontal insulation layer 116, the second horizontal conductive layer 114, and the stacking structure 120s may be formed on the second substrate 110. By alternately stacking interlayer insulation layers 132 and sacrificial insulation layers 130s, the stacking structure 120s may be formed.

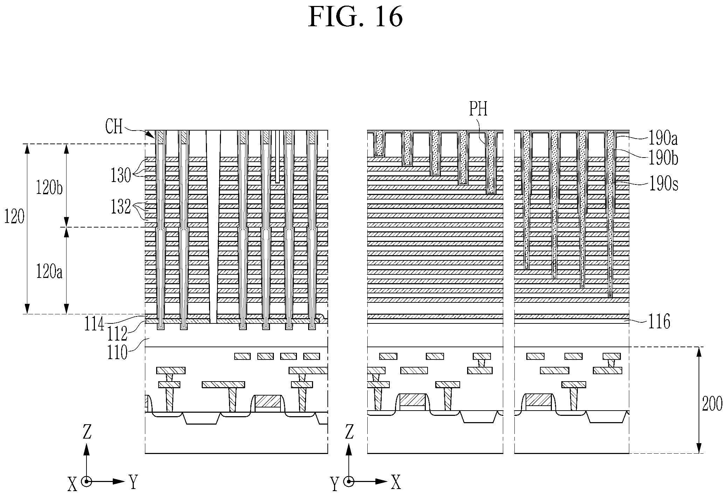

The sacrificial insulation layer 130s may be a layer that will be replaced with a gate electrode 130 (refer to FIG. 16) through a subsequent process. The sacrificial insulation layer 130s may be formed to correspond to a portion where the gate electrode 130 will be formed. At least a partial portion of the horizontal insulation layer 116 may be a layer that will be replaced with a first horizontal conductive layer 112 (refer to FIG. 16) through a subsequent process. The horizontal insulation layer 116 may be formed to include a portion where the first horizontal conductive layer 112 will be formed.

The horizontal insulation layer 116 and/or the sacrificial insulation layer 130s may include a material different from a material of the interlayer insulation layer 132. For example, the interlayer insulation layer 132 may include or be formed of silicon oxide, silicon nitride, silicon oxynitride, a low dielectric constant material, or so on. The sacrificial insulation layer 130s may include at least one of silicon, silicon oxide, silicon carbide, or silicon nitride, and may include a material different from a material of the interlayer insulation layer 132.

In an embodiment, the stacking structure 120s may include a plurality of stacking structures 120d and 120e sequentially stacked on the second substrate 110. The channel sacrificial layer 122s may include a plurality of channel sacrificial portions that pass through or penetrate the plurality of stacking structures 120d and 120e, respectively. However, the embodiments are not limited thereto.

In an embodiment, the stacking structure 120s may be disposed in a region of the cell array region 102 where the channel sacrificial layer 122s is disposed and in a region of the connection region 104 where a gate contact portion 190 (refer to FIG. 17) will be disposed.

A preliminary penetrating portion that passes through or penetrates the stacking structure 120s may be formed at a portion where a channel structure CH (refer to FIG. 16) will be formed, and the preliminary penetrating portion may be filled with a sacrificial material to form the channel sacrificial layer 122s. The preliminary penetrating portion may be formed through an etching process (e.g., a dry etching process) or so on, and the preliminary penetrating portion may be filled by any of various processes (e.g., a deposition process or so on). The channel sacrificial layer 122s may include or be formed of at least one of polycrystalline silicon, tungsten, titanium nitride, or carbon. However, the embodiments are not limited thereto, and the channel sacrificial layer 122s may include any of various materials.

Subsequently, as illustrated in FIG. 8 to FIG. 14, a plurality of through holes PH for a plurality of gate contact portions 190 may be formed by a plurality of partial etching processes (e.g., first to fourth partial etching processes E1, E2, E3, and E4) and/or an additional etching process EA. A first layer 190a may be formed between two sequential processes of the plurality of partial etching processes.

For a clear understanding and simple illustration, in FIG. 8 to FIG. 14 and the description thereof, it is described and illustrated as an example that a number of sacrificial insulation layers 130s are sixteen, and first to fourth partial etching processes E1, E2, E3, and E4 and one additional etching process EA are performed. For a clear understanding, in FIG. 8 to FIG. 14, positions of first to fifth through holes PH1 to PH5 that correspond to first to fifth gate contact portions and positions of thirteenth to sixteenth through holes PH13 to PH16 that correspond to thirteenth to sixteenth gate contact portions are illustrated. However, the embodiments are not limited thereto, and a number of the sacrificial insulation layers 130s may be variously modified, and a number of partial etching processes and/or a number of the additional etching process EA may be variously modified according to the number of the sacrificial insulation layers 130s.

In an embodiment, a number of interlayer insulation layers 132 on each sacrificial insulation layer 130s may be converted to binary system. For example, a position or a level of each sacrificial insulation layer 130s in the vertical direction may be converted to binary system. According to them, a plurality of partial etching processes (e.g., first to fourth partial etching processes E1, E2, E3, and E4) and/or an additional etching process EA may be performed to form the plurality of through holes PH having different depths.

The plurality of partial etching processes (e.g., the first to fourth partial etching processes E1, E2, E3, and E4) may be cyclic etching processes. In each partial etching process, a mask may be formed, the partial etching process according to binary system may be performed, and the mask may be removed. For example, the through holes PH may be formed by etching the interlayer insulation layer 132 and a layer or layers (e.g., the sacrificial insulation layer 130s or the sacrificial insulation layers 130s (refer to FIG. 7)) thereon according to the binary system. For example, in the plurality of partial etching processes, the interlayer insulation layer 132 or the interlayer insulation layers 132 of 1, 2, 4,..., 2^{(m-1)} and the sacrificial insulation layer 130s or the sacrificial insulation layers 130s thereon may be etched. The m may be a natural number greater than 1, and be a total number of the partial etching processes. The m-th partial etching process may be a longest partial etching process of etching a longest depth. An etching depth of the m-th partial etching process may be greater than an etching depth of another partial etching process and the additional etching process EA.

For example, a position (i.e., 1) of a first interlayer insulation layer that is disposed at the uppermost position is converted to 1 according to the binary system, and the first interlayer insulation layer that is disposed at the uppermost position may be etched by the first partial etching process E1 and a first through hole PH1 that reaches a first sacrificial insulation layer may be formed. A position (i.e., 5) of a fifth interlayer insulation layer that is disposed at fifth from an upper portion is converted to 101 according to the binary system, and a fifth through hole PH5 that reaches a fifth sacrificial insulation layer may be formed by performing the first partial etching process E1 and the third partial etching process E3. A position (i.e., 15) of a fifteenth interlayer insulation layer that is disposed at fifteenth from the upper portion is converted to 1111 according to the binary system, and a fifteenth through hole PH15 that reaches a fifteenth sacrificial insulation layer may be formed by performing the first partial etching process E1, the second partial etching process E2, the third partial etching process E3, and the fourth partial etching process E4. A position (i.e., 16) of a sixteenth interlayer insulation layer that is disposed at sixteenth from the upper portion is a sum of 1111 according to the binary system and one, and a sixteen through hole PH16 that reaches a sixteenth sacrificial insulation layer may be formed by performing the first partial etching process E1, the second partial etching process E2, the third partial etching process E3, the fourth partial etching process E4, and the additional etching process EA.

In an embodiment, between two sequential processes included in the plurality of partial etching processes (e.g., the first to fourth partial etching processes E1, E2, E3, and E4), the first layer 190a may be formed. Based on the first layer 190a, the partial etching process performed before the process of forming the first layer 190a may be referred to as a preceding partial etching process, and the partial etching process performed after the process of forming the first layer 190a may be referred to as a succeeding partial etching process. The fourth partial etching process E4 of etching the longest depth may be referred to as the longest partial etching process.

In an embodiment, the process of forming the first layer 190a may be performed before the longest partial etching process. For example, the first layer 190a may be formed between the third partial etching process E3 and the fourth partial etching process E4 of the longest partial etching process. The first to third partial etching processes E1, E2, and E3 may be the preceding partial etching processes, and the fourth partial etching process E4 of the longest partial etching process may be the succeeding partial etching process.

More particularly, as illustrated in FIG. 8, in the first partial etching process E1, portions of a plurality of through holes PH that correspond to the first partial etching process E1 may be selectively etched. For example, in the first partial etching process E1, in portions that correspond to a first through hole PH1, a third through hole PH3, a fifth through hole PH5, a seventh through hole, a ninth through hole, an eleventh through hole, a thirteenth through hole PH13, a fifteenth through hole PH15, and a sixteenth through hole PH16, one interlayer insulation layer 132 (e.g., a first interlayer insulation layer that is disposed at the uppermost position) may be etched.

In the first partial etching process E1 of the preceding partial etching process, a photoresist layer including or being formed of a photosensitive material may be used as a mask. For example, a first photoresist mask M1 may be formed by forming the photoresist layer on the stacking structure 120s and performing a patterning process of forming a first opening P1 in a portion where the first partial etching process E1 will be performed. The patterning process of forming the first opening P1 may be formed by a photolithography process. Thereby, in the patterning process of forming in the first opening P1, an etching process may be omitted and the first photoresist mask M1 may be formed without damage to the stacking structure 120s.

In portions that are exposed by first openings P1 of the first photoresist mask M1, the first partial etching process E1 of etching one interlayer insulation layer 132 (e.g., the first interlayer insulation layer that is disposed at the uppermost position) may be performed. The first partial etching process E1 may be performed by any of various etching processes (e.g., a dry etching process). After the etching process, the first photoresist mask M1 may be removed. For a process of removing the first photoresist mask M1, any of various processes may be used.

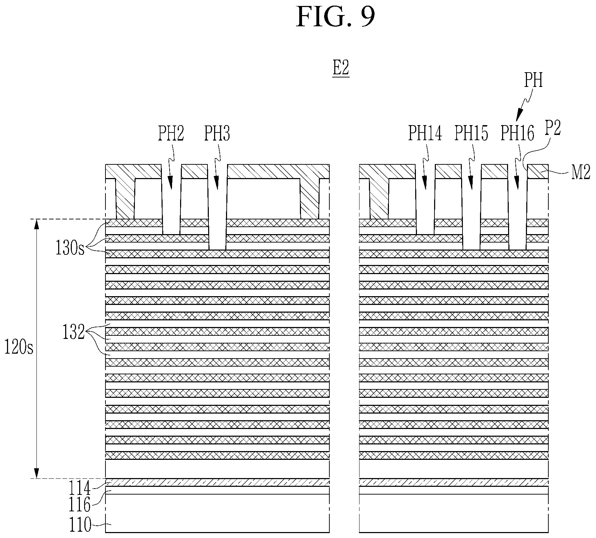

Subsequently, as illustrated in FIG. 9, in the second partial etching process E2, portions of the plurality of through holes PH that correspond to the second partial etching process E2 may be selectively etched. For example, in the second partial etching process E2, in portions that correspond to a second through hole PH2, a third through hole PH3, a sixth through hole, a seventh through hole, a tenth through hole, an eleventh through hole, a fourteenth through hole PH14, a fifteenth through hole PH15, and a sixteenth through hole PH16, two interlayer insulation layers 132 and one or two sacrificial insulation layers 130s thereon may be etched. More particularly, in portions that correspond to the second through hole PH2, the sixth through hole, the tenth through hole, and the fourteenth through hole PH14 where the second partial etching process E2 is performed first, two interlayer insulation layers 132 and one sacrificial insulation layer 130s thereon may be etched. In portions that correspond to the third through hole PH3, the seventh through hole, the eleventh through hole, the fifteenth through hole PH15, and the sixteenth through hole PH16 where the second partial etching process E2 is performed after the first partial etching process E1, two interlayer insulation layers 132 and two sacrificial insulation layers 130s thereon may be etched.

In the second partial etching process E2 of the preceding partial etching process, a photoresist layer including or being formed of a photosensitive material may be used as a mask. For example, a second photoresist mask M2 may be formed by forming the photoresist layer on the stacking structure 120s and performing a patterning process of forming a second opening P2 in a portion where the second partial etching process E2 will be performed. The patterning process of forming the second opening P2 may be formed by a photolithography process. Thereby, in the patterning process of forming in the second opening P2, an etching process may be omitted and the second photoresist mask M2 may be formed without damage to the stacking structure 120s.

In portions that are exposed by second openings P2 of the second photoresist mask M2, the second partial etching process E2 of etching two interlayer insulation layers 132 and one or two sacrificial insulation layers 130s thereon may be performed. The second partial etching process E2 may be performed by any of various etching processes (e.g., a dry etching process). After the etching process, the second photoresist mask M2 may be removed. For a process of removing the second photoresist mask M2, any of various processes may be used.

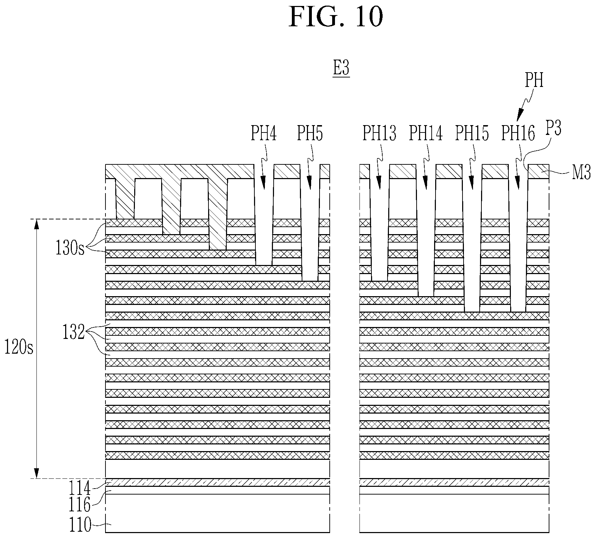

Subsequently, as illustrated in FIG. 10, in the third partial etching process E3, portions of the plurality of through holes PH that correspond to the third partial etching process E3 may be selectively etched. For example, in the third partial etching process E3, in portions that correspond to a fourth through hole PH4, a fifth through hole PH5, a sixth through hole, a seventh through hole, a twelfth through hole, a thirteenth through hole PH13, a fourteenth through hole PH14, a fifteenth through hole PH15, and a sixteenth through hole PH16, four interlayer insulation layers 132 and three or four sacrificial insulation layers 130s thereon may be etched. More particularly, in a portion that corresponds to the fourth through hole PH4 where the third partial etching process E3 is performed first, four interlayer insulation layers 132 and three sacrificial insulation layer 130s thereon may be etched. In portions that correspond to the fifth through hole PH5, the sixth through hole, the seventh through hole, the twelfth through hole, the thirteenth through hole PH13, the fourteenth through hole PH14, the fifteenth through hole PH15, and the sixteenth through hole PH16 where the third partial etching process E3 is performed after the first partial etching process E1 and/or the second partial etching process E2, four interlayer insulation layers 132 and four sacrificial insulation layers 130s thereon may be etched.

In the third partial etching process E3 of the preceding partial etching process, a photoresist layer including or being formed of a photosensitive material may be used as a mask. For example, a third photoresist mask M3 may be formed by forming the photoresist layer on the stacking structure 120s and performing a patterning process of forming a third opening P3 in a portion where the third partial etching process E3 will be performed. The patterning process of forming the third opening P3 may be performed by a photolithography process. Thereby, in the patterning process of forming in the third opening P3, an etching process may be omitted and the third photoresist mask M3 may be formed without damage to the stacking structure 120s.

In portions that are exposed by third openings P3 of the third photoresist mask M3, the third partial etching process E3 of etching four interlayer insulation layers 132 and three or four sacrificial insulation layers 130s thereon may be performed. The third partial etching process E3 may be performed by any of various etching processes (e.g., a dry etching process). After the etching process, the third photoresist mask M3 may be removed. For a process of removing the third photoresist mask M3, any of various processes may be used.

As in the above, after the first to third partial etching processes E1, E2, and E3 of the preceding partial etching process, as illustrated in FIG. 11, the first layer 190a may be formed. Accordingly, between the first to third partial etching processes E1, E2, and E3 of the preceding partial etching processes and the fourth partial etching process E4 of the succeeding partial etching process, the first layer 190a may be formed.

The first layer 190a may be formed inside each of the plurality of through holes PH. For example, the first layer 190a may be formed on an inner side surface and a lower surface in each of the plurality of through holes PH, and may be further formed on an upper surface of the stacking structure 120s. The process of forming the first layer 190a may be performed by any of various processes (e.g., a deposition process or so on). However, the embodiments are not limited thereto.

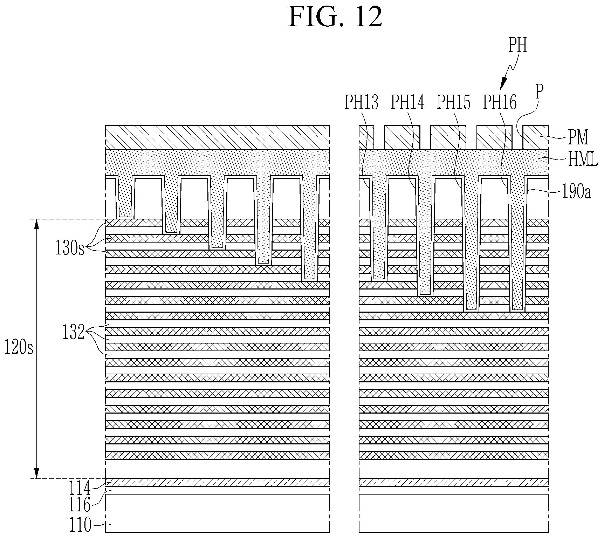

Subsequently, as illustrated in FIG. 12 and FIG. 13, in the fourth partial etching process E4, portions of the plurality of through holes PH that correspond to the fourth partial etching process E4 may be selectively etched. For example, in the fourth partial etching process E4, in portions that correspond to eighth to twelfth through holes, thirteenth to sixteenth through holes PH13, PH14, PH15, and PH16, eight interlayer insulation layers 132 and seven or eight sacrificial insulation layers 130s thereon may be etched.

In the fourth partial etching process E4 of the succeeding partial etching process, a hard mask layer HML or a hard mask HM may be used as a mask. For example, as illustrated in FIG. 12, the hard mask layer HML may be formed on the stacking structure 120s and a patterning mask layer PM may be formed. The pattering mask layer PM that includes an opening P corresponding to a fourth opening P4 (refer to FIG. 13) may be performed. A patterning process of removing a portion of the hard mask layer HML exposed by the opening P of the patterning mask layer PM may be performed. In the patterning process of the hard mask layer HML, an etching material that is capable of etching the hard mask layer HML more than a material included in the first layer 190a and/or the stacking structure 120s or that is capable of etching the hard mask layer HML and does not etch the material included in the first layer 190a and/or the stacking structure 120s may be used. Thereby, as illustrated in FIG. 13, the hard mask HM having the fourth opening P4 may be formed.

The hard mask HM may include any of various materials having high selectivity and being capable of being easily removed. For example, the hard mask HM may include or be formed of a carbon-based material including carbon. The hard mask HM may include or be formed of a spin on hard mask (SOH), an amorphous carbon layer (ACL), or so on. However, the embodiments are not limited thereto, and a material of the hard mask HM may be variously modified.

In portions exposed through fourth openings P4 of the hard mask HM, the fourth partial etching process E4 of etching the eight interlayer insulation layers 132 and the seven or eight sacrificial insulation layers 130s thereon may be performed. The fourth partial etching process E4 may be performed by any of various etching processes (e.g., a dry etching process). In the fourth partial etching process E4, an etching material that does not etch the hard mask HM or etches the hard mask HM less than the stacking structure 120s may be used. After the etching process, the hard mask HM may be removed. For a process of removing the hard mask HM, any of various processes may be used.

By the etching material in the fourth partial etching process E4, the hard mask HM might not be etched or may be etched relatively less. By the etching material in the fourth partial etching process E4, the hard mask HM may be etched less than the first to third photoresist mask M1, M2, and M3. Accordingly, in the fourth partial etching process E4 of the longest partial etching process, a limit of an etching depth may be overcome. In the fourth partial etching process E4, the through hole PH may be formed to stably reach a desirable layer. Accordingly, a process margin may be secured.

In the fourth partial etching process E4 of the longest partial etching process, the hard mask HM may be remained to have a sufficient thickness. Thereby, damage to the stacking structure 120s that may be induced when a thickness of a remained mask in an etching process is small may be prevented. For example, in a comparative example where a thickness of a remained mask (e.g., a remained photoresist mask) in an etching process is small, ions may be reflected at a side surface of the mask and a portion of a stacking structure adjacent to an upper portion of a through hole may be undesirably etched. Therefore, a diameter or a width of the through hole may increase and interference between adjacent through holes may be induced, and an electric property may be deteriorated.

In an embodiment, a lower portion of the first layer 190a on the sacrificial insulation layer 130s may protect the sacrificial insulation layer 130s in the patterning process of the hard mask layer HML. For example, in a process of removing the hard mask layer HML in the through hole PH having a relatively large depth, the first layer 190a in the through hole PH having a relatively small depth may protect the sacrificial insulation layer 130s under the first layer 190a. Thereby, in the patterning process of the hard mask layer HML, an unwanted damage or puncture of the sacrificial insulation layer 130s may be prevented. Thereby, the through hole PH may be stably formed to reach a desired position.

Further, in the fourth partial etching process E4, a side portion of the first layer 190a on a side surface of the stacking structure 120s may prevent damage to the side surface of the stacking structure 120s. For example, in the etching process, ions may be reflected at a side surface of a mask and the side surface of the stacking structure 120s adjacent to the upper portion of the through hole PH may be etched. The side portion of the first layer 190a may prevent unwanted etching of the side surface of the stacking structure 120s.

In an embodiment, the first layer 190a may be formed before the longest partial etching process is performed, and a depth of the through hole PH formed by the longest partial etching process may increase. Thereby, a number of processes of forming the through hole PH having a relatively large depth may be reduced and cost and time of a manufacturing process may be reduced. In an embodiment, the first layer 190a may be formed before the longest partial etching process may be performed, and the damage of the stacking structure 120s that may be induced in the longest partial etching process may be minimized.

On the other hand, in a comparative example using a photoresist mask in a longest partial etching process, the photoresist mask may be easily etched and there may be a limit to form a through hole having a relatively large depth. Accordingly, to perform an etching process to have a large etching depth, a plurality of etching processes, each having a small etching depth, may be repeatedly performed. Thereby, a number of processes of forming a through hole may be large and there may be difficult to reduce cost and time of a manufacturing process.

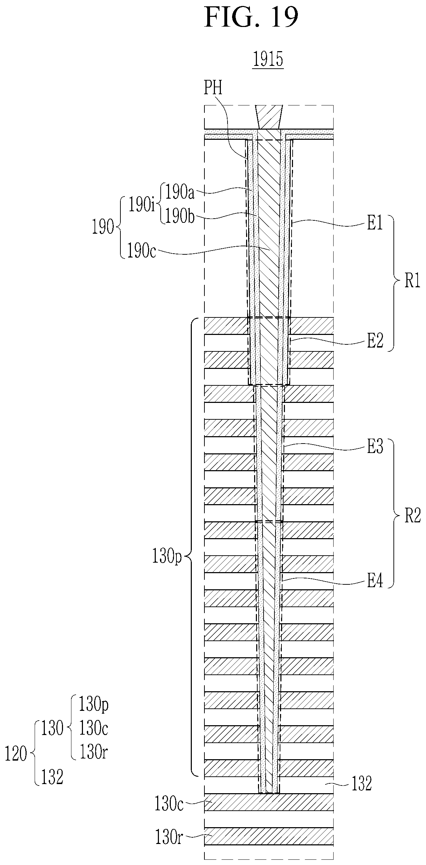

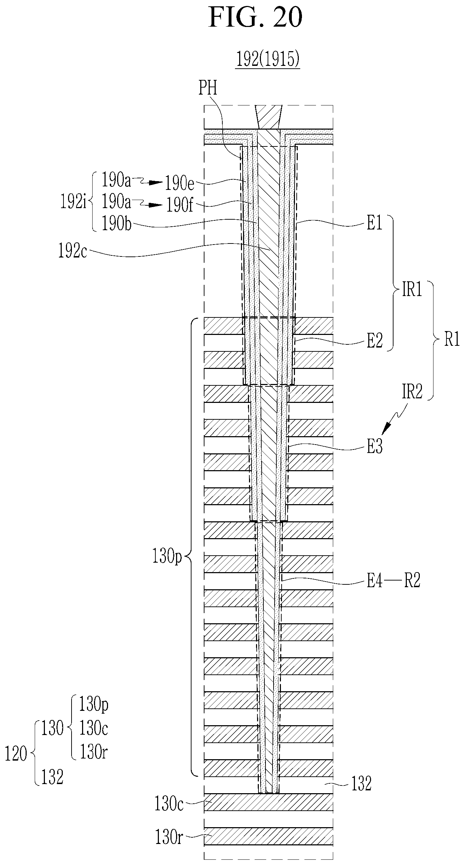

However, the embodiments are not limited thereto, and an order, a number, or so on of the process of forming the first layer 190a may be variously modified. Other embodiments will be described later with reference to FIG. 19 and FIG. 20.

In an embodiment, the plurality of through holes PH may be formed by using the plurality of partial etching processes according to the binary system, and a number of the etching processes of forming the plurality of through holes PH may be largely reduced.

As illustrated in FIG. 14, in the additional etching process EA, in a portion that corresponds to the additional etching process EA may be selectively etched. For example, in the additional etching process EA, in a portion that corresponds to a sixteenth through hole PH16, one interlayer insulation layer 132 and one sacrificial insulation layer 130s thereon may be etched. In the additional etching process EA, a photoresist layer including or being formed of a photosensitive material may be used as a mask. The description of the photoresist layer with reference to FIG. 8 to FIG. 10 may be applied.

In an embodiment, it is illustrated and described as an example that a number of the through hole PH at which the additional etching process EA is performed is one, but a plurality of through holes PH at which the additional etching process EA is performed may be included. In the additional etching process EA, a partial etching process according to the binary system may be performed, or a partial etching process sequentially performed may be performed.

In the above description, it is illustrated as an example that the additional etching process EA is be performed after the plurality of partial etching processes are performed. However, the embodiments are not limited thereto, and the additional etching process EA may be performed before the plurality of partial etching processes or between two processes of the plurality of partial etching processes. For example, the additional etching process EA may be performed between the preceding partial etching process and the succeeding partial etching process (e.g., between the preceding partial etching process and the process of forming the first layer 190a). Other various modifications are possible.

Subsequently, as illustrated in FIG. 15, a side insulation layer 190i may be formed by forming a second layer 190b inside the through hole PH (e.g., on an inner surface of the through hole PH and the first layer 190a on the inner surface of the through hole PH). After the side insulation layer 190i is formed, a through sacrificial layer 190s may be formed on the first layer 190a and/or on the second layer 190b on the inner surface of the through hole PH. The through sacrificial layer 190s may include or be formed of at least one of polycrystalline silicon, tungsten, titanium nitride, or carbon. However, the embodiments are not limited thereto, and the through sacrificial layer 190s may include any of various materials.

Subsequently, as illustrated in FIG. 16, a channel structure CH, gate electrodes 130, and a separation structure 146 may be formed.

More particularly, a through portion may be formed by removing the channel sacrificial layer 122s (refer to FIG. 7). A process of forming the through portion may be performed by any of various etching processes (e.g., a dry etching process). In an embodiment, a gate dielectric layer 150 (refer to FIG. 2), a channel layer 140 (refer to FIG. 2), and a core insulation layer 142 (refer to FIG. 2) may be sequentially formed in the through portion, and a channel pad 144 (refer to FIG. 2) may be formed. A process of forming the gate dielectric layer 150, the channel layer 140, the core insulation layer 142, or the channel pad 144 may performed by any of various processes (e.g., a deposition process or so on).

An opening for a separation structure that penetrates the stacking structure 120s may be formed in an area corresponding to the separation structure 146, the sacrificial insulation layers 130s (refer to FIG. 15) may be replaced with gate electrodes 130, and the opening for the separation structure may be filled with an insulating material or so on to form the separation structure 146.

In an embodiment, the opening for the separation structure may be formed by an etching process (e.g., a dry etching process or so on). The sacrificial insulation layers 130s may be selectively removed by an etching process (e.g., a wet etching process) through the opening for the separation structure. The gate electrodes130 may be formed by filling portions from which the sacrificial insulation layers 130s were removed with a conductive material. As a result, areas where the sacrificial insulation layers 130s were disposed may be replaced with the gate electrodes 130. In this instance, a process of forming a partial portion of a blocking layer 156 (refer to FIG. 2) (for example, a first blocking layer 156a (refer to FIG. 2)) may be further performed before the process of filing the conductive material constituting the gate electrodes 130. However, the embodiments are not limited thereto. The opening for the separation structure may be filled by any of various processes (e.g., a deposition process or so on).

In some embodiments, the opening for the separation structure 146 may expose the horizontal insulation layer 116. In the etching process through the opening for the separation structure, at least a partial portion of the horizontal insulation layer 116 and at least a partial portion of the gate dielectric layer 150 may be removed, and a material of a first horizontal conductive layer 112 may be filled. Thereby, the first horizontal conductive layer 112 may be formed.

In some embodiments, an upper separation region 148 may be formed at a partial portion of the gate stacking structure 120. The upper separation region 148 may be formed by forming an opening for a separation pattern through an etching process using a mask layer and filling an insulating material to at least a partial portion of the opening for the separation pattern. The opening for the separation pattern may be formed by an etching process (e.g., a dry etching process or so on). The opening for the separation pattern may be filled by any of various processes (e.g., a deposition process or so on). An order of the process of forming the opening of the separation structure and the process of forming the opening of the separation pattern may be variously modified.

In an embodiment, it is described as an example that the opening for the separation structure 146 is formed after the through hole PH, the side insulation layer 190i, and the through sacrificial layer 190s are formed. However, the embodiments are not limited thereto. In some embodiments, the opening for the separation structure 146 may be formed before the through hole PH is formed, and a sacrificial layer may be formed in the opening for the separation structure 146. In this instance, after the sacrificial layer in the opening for the separation structure 146 is removed, a replacement process of the gate electrodes 130, a replacement process of the first horizontal conductive layer 112, or so on may be performed.

Subsequently, as illustrated in FIG. 17, the sacrificial layer 190s (refer to FIG. 16) may be removed and a lower portion of the second layer 190b (i.e., a portion of the second layer 190b on the gate electrode 130) may be removed. The conductive portion 190c may be formed by filling the through hole PH with a conductive material. Thereby, a gate contact portion 190 may be formed.

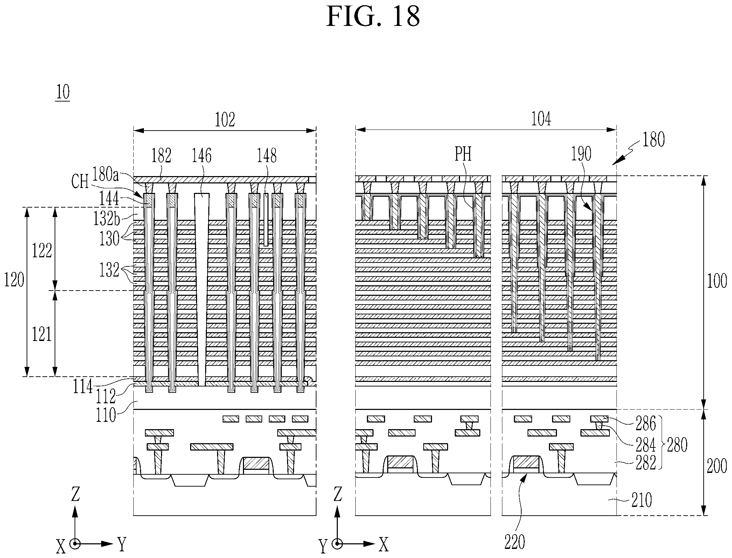

Subsequently, as illustrated in FIG. 18, a second wiring portion 180 that includes a bit line 182 electrically connected to the channel structure CH or so on may be formed.

According to an embodiment, the plurality of through holes PH may be formed using the partial etching processes according to the binary system, and a number of processes of forming the plurality of through holes PH may be reduced. In the preceding partial etching process performed before the process of forming the first layer 190a, the photoresist layer may be used as a mask to prevent damage to the stacking structure 120s. In the succeeding partial etching process performed after the process of forming the first layer 190a, damage to the stacking structure 120s may be prevented by the first layer 190a even when the hard mask HM is used as a mask. Accordingly, the succeeding partial etching process using the hard mask HM may be performed, and the depth of the through hole PH may increase and a number of etching processes of forming the through holes PH may be reduced. As a result, cost and time of a manufacturing process may be reduced.

In the drawings, it is illustrated as an example that the through holes PH (e.g., the thirteenth to sixteenth through hole PH13, PH14, PH15, and PH16) formed by the plurality of partial etching processes (e.g., the first to fourth partial etching processes E1, E2, E3, and E4) and/or the additional etching process EA pass through or penetrate a plurality of gate stacking portions 121 and 122. However, the embodiments are not limited thereto. The through hole PH may be formed to correspond to each of the plurality of gate stacking portions 121 and 122, and may include a plurality of portions corresponding to the plurality of gate stacking portions 121 and 122, respectively.

In the above description, it is described as an example that the semiconductor device 10 is a NAND flash memory device, the gate stacking structure 120 and the channel structure CH are included as the memory cell structure, and the gate contact portion 190 electrically connected to the gate electrode 130 is included.

However, the embodiments are not limited thereto. In some embodiments, a semiconductor device may include an electrode stacking structure formed by stacking two layers having different materials. The semiconductor device may include an electrode stacking structure including a plurality of interlayer insulation layers and a plurality of electrodes alternately stacked on each other. For example, the electrode stacking structure may be formed by alternately stacking a plurality of semiconductor material layers (e.g., silicon layers) and a plurality of interlayer insulation layers (e.g., oxide layers). A plurality of electrode contact portions may be electrically connected to a plurality of electrodes, respectively. The plurality of electrode contact portions may have a shape or a structure corresponding to a shape or a structure of the gate contact portion 190. For example, the gate contact portions 190 may also be referred to as a plurality of electrode contact portions. The description of the electrical connection structure between the gate contact portion 190 and the gate electrode 130 may be applied to an electrical connection structure between the electrode contact portion and the electrode, and the description of the gate contact portion 190 may be applied to the electrode contact portion. For example, the semiconductor device including the electrode contact portion having a shape or a structure corresponding to a shape or a structure of the gate contact portion 190 may be a DRAM or so on.

In the above description, the electrode stacking structure including the plurality of electrodes and the plurality of interlayer insulation layers is illustrated as an example. In some embodiments, a stacking structure formed by alternatively stacking two semiconductor material layers (e.g., silicon layers and silicon-germanium layers) including different materials may be applied. Other various modifications are possible.

Hereinafter, referring to FIG. 19 to FIG. 22, semiconductor devices and manufacturing methods thereof according to embodiments will be described in more detail. To the extent that an element is not described in detail below, it may be understood that the element is substantially the same as a corresponding element that has been described elsewhere within the present disclosure. A portion which is not described in the above will be described in detail.

FIG. 19 is a cross-sectional view that illustrates a gate contact portion included in a semiconductor device according to an example embodiment. FIG. 19 illustrates a portion corresponding to FIG. 4. For a clear understanding, it is described as an example that sixteen gate electrodes 130 or sixteen sacrificial insulation layers are included, and through holes PH may be formed by first to fourth partial etching processes E1, E2, E3, and E4 and one additional etching process EA. However, the embodiments are not limited thereto, and a number of the gate electrodes 130 or the sacrificial insulation layers may be variously modified, or a number of the partial etching processes and/or the additional etching processes may be variously modified according to the number of gate electrodes 130 or the sacrificial insulation layers.

Referring to FIG. 19, in an embodiment, a succeeding partial etching process performed after a process of forming a first layer 190a may include a plurality of partial etching processes. For example, the first layer 190a might not be performed just before a longest partial etching process.

This will be described using a fifteenth gate contact portion 1915 as an example. To form a fifteenth gate contact portion 1915, first and second partial etching processes E1 and E2 of preceding partial etching processes may be performed, the first layer 190a may be formed in a portion formed by the first and second partial etching processes E1 and E2, third and fourth partial etching processes E3 and E4 of succeeding partial etching processes may be performed, and a second layer 190b and a conductive portion 190c may be formed. Thereby, a first portion R1 where the first layer 190a and the second layer 190b are disposed together are disposed may be disposed in the portion formed by the first and second partial etching processes E1 and E2, and a second portion R2 where the second layer 190b is disposed alone without the first layer 190a may be disposed in a portion formed by the third and the fourth partial etching processes E3 and E4.

As in the above, an order of the process of forming the first layer 190a, a number of the succeeding partial etching processes, or so on may be variously modified.

FIG. 20 is a cross-sectional view that illustrates a gate contact portion included in a semiconductor device according to an example embodiment. FIG. 20 illustrates a portion corresponding to FIG. 4. For a clear understanding, it is described as an example that sixteen gate electrodes 130 or sixteen sacrificial insulation layers are included, and through holes PH may be formed by first to fourth partial etching processes E1, E2, E3, and E4 and one additional etching process EA. However, the embodiments are not limited thereto, and a number of the gate electrodes 130 or the sacrificial insulation layers may be variously modified, or a number of the partial etching processes and/or the additional etching processes may be variously modified according to the number of gate electrodes 130 or the sacrificial insulation layers.

Referring to FIG. 20, in an embodiment, a process of forming a first layer 190a may include a plurality of processes. Hereinafter, to distinguish from each other, a first layer 190a formed first may be referred to as a first cover layer 190e and a first layer 190a formed later may be referred to as a second cover layer 190f.

It is described as an example that the first cover layer 190e is formed between a second partial etching process E2 and a third partial etching process E3, and the second cover layer 190f is formed between a third partial etching process E3 and a fourth partial etching process E4. Based on the first cover layer 190e, the first and second partial etching processes E1 and E2 may be preceding partial etching processes, and the third partial etching process E3 may be a succeeding partial etching process. Based on the second cover layer 190f, the third partial etching process E3 may be a preceding partial etching process, and the fourth partial etching process E4 may be a succeeding partial etching process.

This will be described using a fifteenth gate contact portion 1915 as an example. First, the first and second partial etching processes E1 and E2 of the preceding partial etching process based on the first cover layer 190e may be performed, the first cover layer 190e may be formed in a portion formed by the first and second partial etching processes E1 and E2, and the third partial etching process E3 of the succeeding partial etching process based on the first cover layer 190e may be performed. Subsequently, the second cover layer 190f may be formed in a second insulation portion IR2 formed by the first to third partial etching processes E1, E2, and E3, and the fourth partial etching process E4 of the succeeding partial etching process may be performed. Subsequently, a second layer 190b and a first conductive portion 192c may be formed. Thereby, the fifteenth gate contact portion 1915 may be formed.

The first side insulation layer 192i of the first contact portion 192 may include a first portion R1, and a second portion R2 that has a thickness smaller than a thickness of the first portion R1. The first portion R1 may include a first insulation portion IR1 and a second insulation portion IR2. The first insulation portion IR1 may be a portion where the first cover layer 190e, the second cover layer 190f, and the second layer 190b are disposed. The second insulation portion IR2 may be a portion where the second cover layer 190f and the second layer 190b are disposed without the first cover layer 190e. The second portion R2 may be a portion where the second layer 190b is disposed without the first layer 190a (i.e., the first cover layer 190e and the second cover layer 190f).

A thickness of the second insulation portion IR2 may be less than a thickness of the first insulation portion IR1, and a thickness of the second portion R2 may be less than a thickness of the second insulation portion IR2. The thickness of the first insulation portion IR1 may refer to an average thickness of the first insulation portion IR1 or a thickness of a portion of the first insulation portion IR1 that is adjacent to the second insulation portion IR2. The thickness of the second insulation portion IR2 may be an average thickness of the second insulation portion IR2 or a thickness of a portion of the second insulation portion IR2 that is adjacent to the first insulation portion IR1 or the second portion R2. The thickness T2 of the second portion R2 may refer to an average thickness of the second portion R2 or a thickness of a portion of the second portion R2 that is adjacent to the second insulation portion IR2.

In a vertical direction (a Z-axis direction in the drawings), the first insulation portion IR1 may be disposed at an upper portion of the first contact portion 192, and may be spaced apart from a lower surface of the first contact portion 192. For example, an upper surface of the first insulation portion IR1 may be disposed to be adjacent to an upper surface of the first contact portion 192. For example, the upper surface of the first insulation portion IR1 may be disposed at a same plane as the upper surface of the first contact portion 192. The lower surface of the first insulation portion IR1 may be spaced apart from the lower surface of the first contact portion 192 while interposing the second insulation portion IR2 and the second portion R2. A lower surface of first insulation portion IR1 may be spaced apart from the lower surface of the first contact portion 192 while interposing a portion corresponding to a plurality of penetrated gate electrodes 130p.

In the vertical direction (the Z-axis direction in the drawings), the second insulation portion IR2 may be disposed between the first insulation portion IR1 and the second portion R2. Accordingly, the second insulation portion IR2 may be spaced apart from the upper surface of the first contact portion 192 while interposing the first insulation portion IR1, and may be spaced apart from the lower surface of the first contact portion 192 while interposing the second portion R2. The lower surface of the second insulation portion IR2 may be spaced apart from the lower surface of the first contact portion 192 while interposing a portion corresponding to at least one penetrated gate electrode 130p.

In the vertical direction (the Z-axis direction in the drawings), the second portion R2 may be disposed at a lower portion of the second insulation portion IR2 or under the second insulation portion IR2.

In an embodiment, a first side insulation layer 192i may include the first cover layer 190e, the second cover layer 190f, and the second layer 190b. The first cover layer 190e may be partially disposed in the first insulation portion IR1. The second cover layer 190e may be partially disposed in the first insulation portion IR1 and the second insulation portion IR2 and on an inner side surface of the first cover layer 190e. The second layer 190b may be disposed in the first insulation portion IR1, the second insulation portion IR2, and the second portion R2 on an inner side surface of the second cover layer 190f.

More particularly, the first cover layer 190e may be disposed on (e.g. in contact with) a side surface of a gate stacking structure 120 in the first insulation portion IR1. The second cover layer 190f may be disposed on (e.g., in contact with) the inner side surface of the first cover layer 190e in the first insulation portion IR1, and may be disposed on (e.g., in contact with) the side surface of the gate stacking structure 120 in the second insulation portion IR2. The second layer 190b may be disposed on the inner side surface of the second cover layer 190f in the first insulation portion IR1 and the second insulation portion IR2, and may be disposed on (e.g., in contact with) the side surface of the gate stacking structure 120 in the second portion R2. However, the embodiments are not limited thereto. In some embodiments, an additional layer may be disposed between two adjacent portions among the gate stacking structure 120, the first cover layer 190e, the second cover layer 190f, and the second layer 190b.

An inner side surface of the first side insulation layer 192i (e.g., the second layer 190b) may be in contact with an outer side surface of the first conductive portion 192c. However, the embodiments are not limited thereto, and an additional layer may be disposed between the inner side surface of the first side insulation layer 192i (e.g., the second layer 190b) and the outer side surface of the first conductive portion 192c.

As in the above, the first cover layer 190e, the second cover layer 190f, and the second layer 190b may be disposed together in the first insulation portion IR1, the second cover layer 190f and the second layer 190b may be disposed in the second insulation portion IR2, and the second layer 190b may be disposed alone without the first cover layer 190e and the second cover layer 190f in the second portion R2. For example, the first portion R1 and the second portion R2 may have different stacking structures in existence or absence of the first cover layer 190e and/or the second cover layer 190f, and the first insulation portion IR1 and the second insulation portion IR2 may have different stacking structures in existence or absence of the first cover layer 190e.

The inner side surface of the first side insulation layer 192i (e.g., the second layer 190b) may have an inclined surface that is inclined to the vertical direction of a semiconductor device (the Z-axis direction in the drawings) without a stepped portion or a bent portion. An outer side surface of the first side insulation layer 192i (e.g., the first cover layer 190e, the second cover layer 190f, and the second layer 190b) may have an inclined surface that is inclined to the vertical direction, a first step may be disposed between the first insulation portion IR1 and the second insulation portion IR2, and a second step may be disposed between the first insulation portion IR1 and the second portion R2. However, the embodiments are not limited thereto, and at least a partial portion of the inner side surface and/or the outer side surface of the first side insulation layer 192i may include a vertical surface that is parallel to the vertical direction of the semiconductor device.

The description of a step S in an embodiment with reference to FIG. 1 to FIG. 6 may be applied to the first step or the second step. The description of the first layer 190a in the embodiment with reference to FIG. 1 to FIG. 6 may be applied to a thickness of the first cover layer 190e or a thickness of the second cover layer 190f. The description of the second layer 190b in the embodiment with reference to FIG. 1 to FIG. 6 may be applied to a thickness of the second layer 190b.

For example, in the direction perpendicular to the side surface of the first side insulation layer 192i, a height of the first or second step, a thickness of the first cover layer 190e, or a thickness of the second cover layer 190f may be 0.5nm or more (e.g., 1nm or more) and/or 20nm or less (e.g., 10nm or less, for example, 5nm or less). However, the embodiments are not limited thereto, and the height of the first or second step, the thickness of the first cover layer 190e, or the thickness of the second cover layer 190f may be less than 0.5nm (e.g., 1nm) and/or be greater than 20nm (e.g., 10nm, as an example, 5nm).

For example, in the direction perpendicular to the side surface of the first side insulation layer 192i, the height of the first or second step, the thickness of the first cover layer 190e, or the thickness of the second cover layer 190f may be the same or less than a thickness of the second layer 190b. However, the embodiments are not limited thereto. In some embodiments, the height of the first or second step, the thickness of the first cover layer 190e, or the thickness of the second cover layer 190f may be greater than the thickness of the second layer 190b.

In an embodiment, the height of the first or second step, the thickness of the first cover layer 190e, or the thickness of the second cover layer 190f in the direction perpendicular to the side surface of the first side insulation layer 192i may be less than a thickness of an interlayer insulation layer 132 or a thickness of the gate electrode 130 in a vertical direction (a Z-axis direction in the drawings). However, the embodiments are not limited thereto. In some embodiments, the height of the first or second step, the thickness of the first cover layer 190e, or the thickness of the second cover layer 190f may be the same as or greater than the thickness of an interlayer insulation layer 132 or the thickness of the gate electrode 130.

For example, the thickness of the second cover layer 190f may be the same as or greater than the thickness of the first cover layer 190e. This may be because an etching depth in the fourth partial etching process E4 performed after the process of forming the second cover layer 190g may be greater than an etching depth in the third partial etching process E3 performed after the process of forming the first cover layer 190e. However, the embodiments are not limited thereto, and the thickness of the second cover layer 190f may be less than the thickness of the first cover layer 190e.

When the first cover layer 190e and the second cover layer 190f include different materials, a boundary between the first cover layer 190e and the second cover layer 190f may be seen or confirmed. When the first cover layer 190e and the second cover layer 190f include the same material, the boundary between the first cover layer 190e and the second cover layer 190f may be seen or confirmed by a manufacturing process. For example, when the first cover layer 190e and the second cover layer 190f are formed by different processes and have different compositions or properties or when a property of an inner side surface of the first cover layer 190e varies as time passes between a process of forming the first cover layer 190e and a process of forming the second cover layer 190f, the boundary between the first cover layer 190e and the second cover layer 190f may be seen or confirmed. When the first cover layer 190e and the second cover layer 190f include the same material and there may be difficulty to confirm the boundary between the first cover layer 190e and the second cover layer 190f, positions of the first cover layer 190e and the second cover layer 190f may be judged or expected by a different in thickness or the first step.

When the first layer 190a included a plurality of layers as in the above, a stacking structure may be protected in the plurality of partial etching processes. In the above description, it is described as an example that the first cover layer 190e and the second cover layer 190f are formed before the third partial etching process E3 and the fourth partial etching process E4, respectively, that are sequentially performed, but the embodiments are not limited thereto. An order of processes of forming the plurality of layers of the first layer 190a, a number of the succeeding partial etching process performed after each of the plurality of layers of first layer 190a, or so on may be variously modified.

In an embodiment, a second side insulation layer included in a second contact portion may include a portion corresponding to the first portion R1 (i.e., the first insulation portion IR1 and the second insulation portion IR2) of the first side insulation layer 192i in an entire portion, and might not include a portion corresponding to the second portion R2. An outer side surface of the second side insulation layer may include a portion corresponding to the first step between a portion corresponding to the first insulation portion IR1 and a portion corresponding to the second insulation portion IR2.

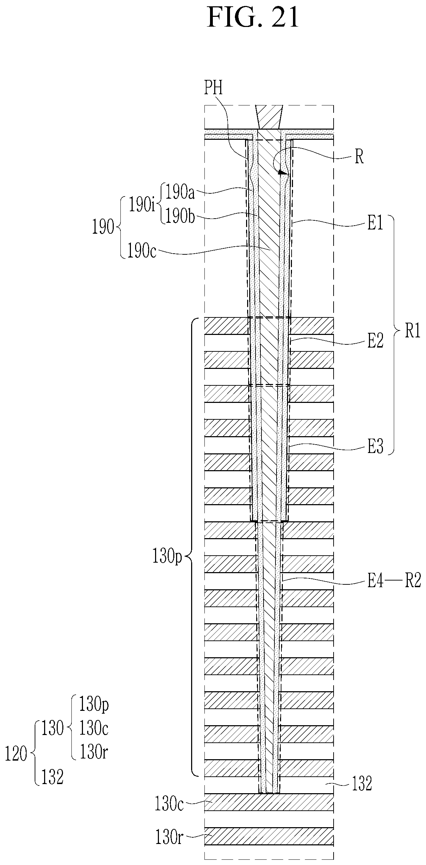

FIG. 21 is a cross-sectional view that illustrates a gate contact portion included in a semiconductor device according to an example embodiment. FIG. 21 illustrates a portion corresponding to FIG. 4.

Referring to FIG. 21, in a semiconductor device according to an embodiment, a recess R may be partially disposed on an inner side surface of a first layer 190a included in a gate contact portion 190. A portion of the first layer 190a having the recess R may have a thickness less than a thickness of another portion of the first layer 190a where the recess R is not disposed. For example, the recess R may be disposed at an upper portion of a gate stacking structure. A partial portion of the first layer 190a may be etched by ions reflected at a side surface of a mask in a succeeding partial etching process and the recess R may be formed. Accordingly, when the ions are reflected at the mask and an unwanted portion is etched, a partial portion of the first layer 190a may be etched. As a result, damage to a stacking structure may be effectively prevented.

In FIG. 21, it is illustrated as an example that the recess R of the first layer 190a may be disposed to correspond to a partial portion of an interlayer insulation layer 132 (i.e., a first interlayer insulation layer) disposed at the uppermost position, but the embodiments are not limited thereto. The recess R of the first layer 190a may be disposed to correspond to at least a partial portion of the interlayer insulation layer 132 or a gate electrode 130.

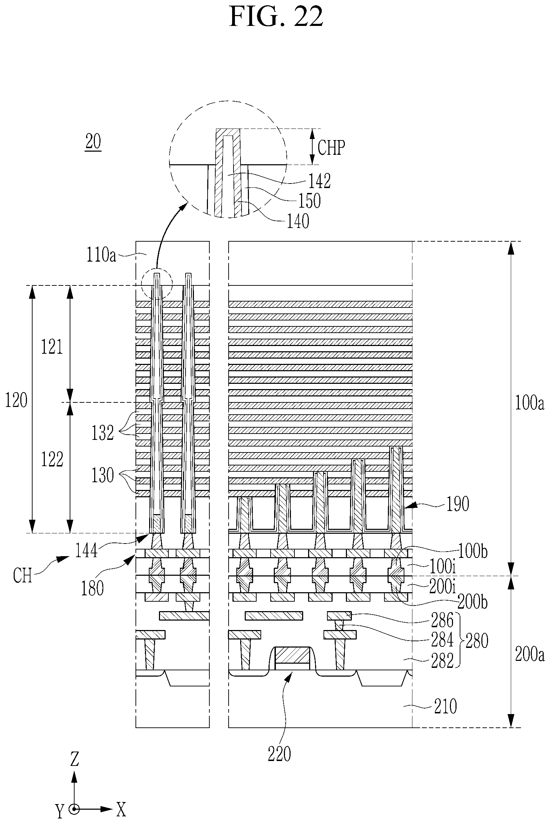

FIG. 22 is a cross-sectional view that schematically illustrates a semiconductor device 20 according to an example embodiment.

Referring to FIG. 22, a semiconductor device 20 according to an embodiment may have a chip-to-chip (C2C) structure bonded by a wafer bonding type. For example, a lower chip including a circuit region 200a where a peripheral circuit structure is disposed on a first substrate 210a may be manufactured, an upper chip including a cell region 100a where a memory cell structure is disposed on a preliminary substrate may be manufactured, and a semiconductor device 20 may be manufactured by bonding the lower chip and the upper chip.

The circuit region 200a may include the first substrate 210, a circuit element 220, a first wiring portion 280, and a first bonding structure 200b electrically connected to the first wiring portion 280 at a surface facing the cell region 100a. A region other than the first bonding structure 200b at the surface facing the cell region 100a may be covered by a first bonding insulation layer 200i.

The cell region 100a may include a second substrate 110a, a gate stacking structure 120, a channel structure CH, a second wiring portion 180, and a second bonding structure 100b electrically connected the second wiring portion 180 at a surface facing the circuit region 200a. A region other than the second bonding structure 100b may be covered by a second bonding insulation layer 100i.

In an embodiment, the second substrate 110a may be a semiconductor layer including a semiconductor material. For example, the second substrate 110a may be a semiconductor layer including or being formed of single-crystalline or polycrystalline silicon, germanium, silicon-germanium, or so on. In some embodiments, the second substrate 110a may further include an insulation layer. For example, the preliminary substrate provided in the cell region 100a may be removed after the cell region 100a is bonded to the circuit region 200a and the semiconductor layer and/or the insulation layer may be formed.

In an embodiment, the gate stacking structure 120 may be sequentially stacked on a lower portion of the second substrate 110a in the drawing, and may have a structure in which the gate stacking structure 120 illustrated in FIG. 1 is disposed in a vertically inverted manner. The channel structure CH penetrating the gate stacking structure 120 may have a structure in which the channel structure CH illustrated in FIG. 2 is disposed in a vertically inverted manner. Accordingly, in a cross-sectional view, the channel structure CH may have an inclined side surface such that a width of the channel structure CH decreases from the circuit region 200a toward the second substrate 110a. A channel pad 144 and the second wiring portion 180 at an upper portion of the gate stacking structure 120 may be adjacent to the circuit region 200a.

For example, the first bonding structure 200b and/or the second bonding structure 100b may include or be formed of aluminum, copper, tungsten, or an alloy including the same. For example, the first and second bonding structures 200b and 100b may include or be formed of copper so that the cell region 100a and the circuit region 200a may be bonded (e.g., directly bonded) to each other by copper-to-copper bonding.

In an embodiment, the channel structure CH may include a protruding portion CHP protruding from a surface of the gate stacking structure 120 opposite to the second wiring portion 180. A gate dielectric layer 150 is not disposed at the protruding portion CHP and a channel layer 140 disposed at the protruding portion CHP may be exposed to an outside. The second substrate 110a may be electrically connected to the channel layer 140 disposed at the protruding portion CHP. However, the embodiments are not limited thereto. In some embodiments, as illustrated in FIG. 1, horizontal conductive layers 112 and 114 may be included. Other various modifications are possible.

In an embodiment, the semiconductor device 20 may include an input/output pad and an input/output connection wiring electrically connect to the input/output pad. The input/output connection wiring may be electrically connected to a part of the second bonding structure 100b. The input/output pad may be disposed, for example, on an insulation layer covering an outer surface of the second substrate 110a. In some embodiments, an additional input/output pad electrically connected to the circuit region 200a may be provided.

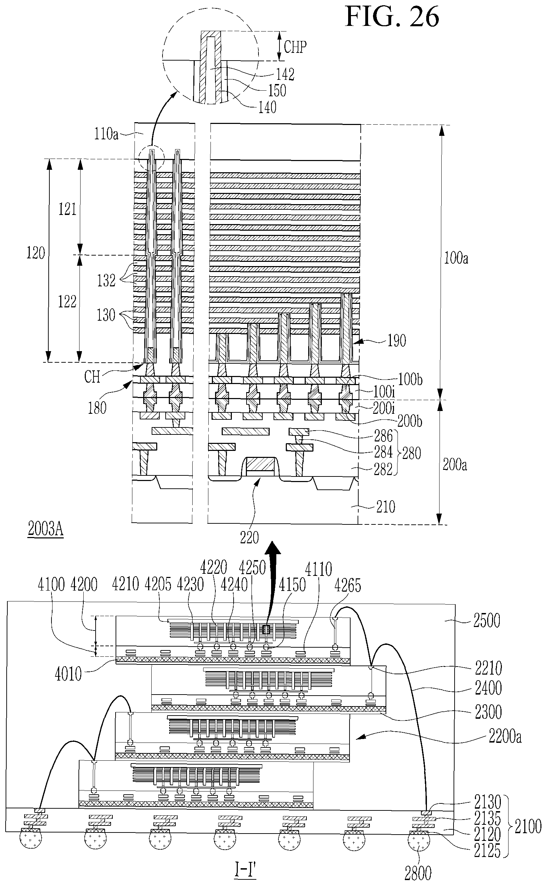

For example, the circuit region 200a and the cell region 100a may be portions corresponding to a first structure 1100F and a second structure 1100S of a semiconductor device 1100 included in an electronic system 1000 illustrated in FIG. 23, respectively. For example, the circuit region 200a and the cell region 100a may be regions including a first structure 4100 and a second structure 4200 of a semiconductor chip 2200a illustrated in FIG. 26, respectively.

An example of an electronic system including a semiconductor device will be described in detail below.

FIG. 23 is a view that schematically illustrates an electronic system including a semiconductor device according to an example embodiment.

Referring to FIG. 23, an electronic system 1000 according to an embodiment may include a semiconductor device 1100 and a controller 1200 that is electrically connected to the semiconductor device 1100. The electronic system 1000 may be a storage device that includes one or a plurality of semiconductor devices 1100 or an electronic device that includes the storage device. For example, the electronic system 1000 may be a solid-state drive (SSD) device, a universal serial bus (USB), a computing system, a medical device, or a communication device that includes one or a plurality of semiconductor devices 1100.

The semiconductor device 1100 may be a non-volatile memory device, and for example, may be a NAND flash memory device described with reference to FIG. 1 to FIG. 22. The semiconductor device 1100 may include a first structure 1100F and a second structure 1100S that is disposed on the first structure 1100F. In some embodiments, the first structure 1100F may be disposed next to the second structure 1100S. The first structure 1100F may be a peripheral circuit structure that includes a decoder circuit 1110, a page buffer 1120, and a logic circuit 1130. The second structure 1100S may be a memory cell structure that includes a bit line BL, a common source line CSL, a word line WL, first and second gate upper lines UL1 and UL2, first and second gate lower lines LL1 and LL2, and a memory cell string CSTR between the bit line BL and the common source line CSL.

In the second structure 1100S, each of memory cell strings CSTR may include lower transistors LT1 and LT2 that are adjacent to the common source line CSL, upper transistors UT1 and UT2 that are adjacent to the bit line BL, and a plurality of memory cell transistors MCT between the lower transistors LT1 and LT2 and the upper transistors UT1 and UT2. A number of the lower transistors LT1 and LT2 and a number of the upper transistors UT1 and UT2 may be variously modified according to an embodiment.

In an embodiment, the lower transistor LT1 or LT2 may include a ground selection transistor, and the upper transistor UT1 or UT2 may include a string selection transistor. The first and second gate lower lines LL1 and LL2 may be gate electrodes of the lower transistors LT1 and LT2, respectively. The word line WL may be a gate electrode of the memory cell transistor MCT, and the gate upper lines UL1 and UL2 may be gate electrodes of the upper transistors UT1 and UT2, respectively.

The common source line CSL, the first and second gate lower lines LL1 and LL2, the word line WL, and the first and second gate upper lines UL1 and UL2 may be electrically connected to the decoder circuit 1110 through a first connection wiring 1115 that extends to the second structure 1100S within the first structure 1100F. The bit line BL may be electrically connected to the page buffer 1120 through a second connection wiring 1125 that extends to the second structure 1100S within the first structure 1100F.

In the first structure 1100F, the decoder circuit 1110 and the page buffer 1120 may execute a control operation for at least one memory cell transistor selected from the plurality of memory cell transistors MCT. The decoder circuit 1110 and the page buffer 1120 may be controlled by the logic circuit 1130. The semiconductor device 1100 may communicate with the controller 1200 through an input/output pad 1101 that is electrically connected to the logic circuit 1130. The input/output pad 1101 may be electrically connected to the logic circuit 1130 through an input/output connection wiring 1135 that extends to the second structure 1100S within the first structure 1100F.

The controller 1200 may include a processor 1210, a NAND controller 1220, and a host interface 1230. In some embodiments, the electronic system 1000 may include a plurality of semiconductor devices 1100, and in this case, the controller 1200 may control the plurality of semiconductor devices 1100.

The processor 1210 may control an overall operation of the electronic system 1000 including the controller 1200. The processor 1210 may operate according to predetermined firmware, and may access the semiconductor device 1100 by controlling the NAND controller 1220. The NAND controller 1220 may include a NAND interface 1221 that processes communication with the semiconductor device 1100. A control command for controlling the semiconductor device 1100, data to be written in the memory cell transistor MCT of the semiconductor device 1100, and data to be read from the memory cell transistor MCT of the semiconductor device 1100, or so on may be transmitted through the NAND interface 1221. The host interface 1230 may provide a communication function between the electronic system 1000 and an external host. When a control command is received from the external host through the host interface 1230, the processor 1210 may control the semiconductor device 1100 in response to the control command.

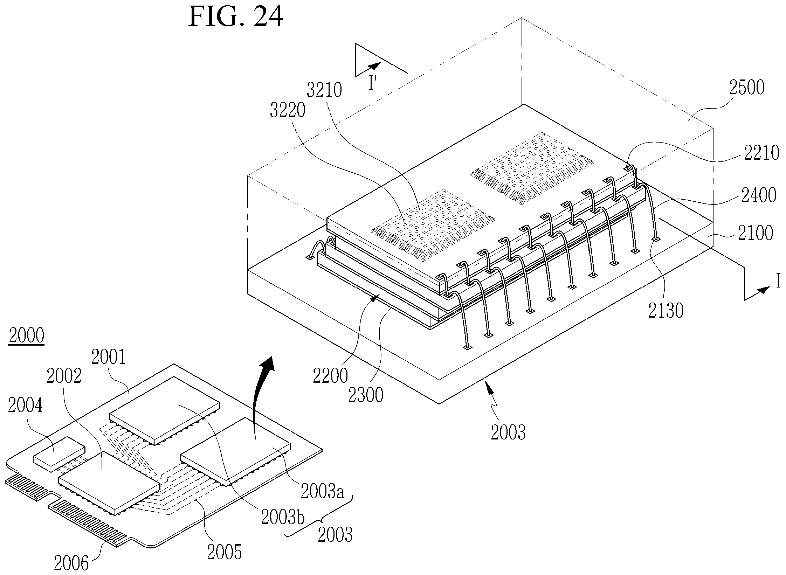

FIG. 24 is a perspective view that schematically illustrates an electronic system including a semiconductor device according to an example embodiment.

Referring to FIG. 24, an electronic system 2000 according to an embodiment may include a main substrate 2001, a controller 2002 that is mounted on the main substrate 2001, one or more semiconductor packages 2003, and a DRAM 2004. The semiconductor package 2003 and the DRAM 2004 may be connected to the controller 2002 through a wiring pattern 2005 that is provided on the main substrate 2001.

The main substrate 2001 may include a connector 2006 that includes a plurality of pins coupled to the external host. A number and an arrangement of the plurality of pins in the connector 2006 may vary depending on a communication interface between the electronic system 2000 and the external host. In an embodiment, the electronic system 2000 may communicate with the external host according to any one of interfaces such as a universal serial bus (USB), a peripheral component interconnect express (PCI-Express), a serial advanced technology attachment (SATA), or an M-Phy for a universal flash storage (UFS). In an embodiment, the electronic system 2000 may operate by power that is supplied from the external host through the connector 2006. The electronic system 2000 may further include a power management integrated circuit (PMIC) that distributes the power supplied from the external host to the controller 2002 and the semiconductor package 2003.

The controller 2002 may write data in the semiconductor package 2003 or may read data from the semiconductor package 2003, and may improve an operating speed of the electronic system 2000.

The DRAM 2004 may be a buffer memory for mitigating or buffering a speed difference between the semiconductor package 2003, which is a data storage space, and the external host. The DRAM 2004 that is included in the electronic system 2000 may also be a kind of cache memory, and may also provide a space for temporarily storing data in a control operation for the semiconductor package 2003. When the electronic system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b that are spaced apart from each other. Each of the first and second semiconductor packages 2003a and 2003b may be a semiconductor package that includes a plurality of semiconductor chips 2200. Each of the first and second semiconductor packages 2003a and 2003b may include a package substrate 2100, the semiconductor chips 2200 that are disposed on the package substrate 2100, an adhesive layer 2300 at a lower surface of each semiconductor chip 2200, a connection structure 2400 that electrically connects the semiconductor chip 2200 and the package substrate 2100, and a molding layer 2500 that covers the semiconductor chip 2200 and the connection structure 2400 on the package substrate 2100.

The package substrate 2100 may be a printed circuit board that includes package upper pads 2130. Each semiconductor chip 2200 may include input/output pads 2210. The input/output pads 2210 may correspond to the input/output pads 1101 of FIG. 23. Each semiconductor chip 2200 may include a gate stacking structure 3210 and a channel structure 3220. Each semiconductor chip 2200 may include a semiconductor device described with reference to FIG. 1 to FIG. 22.

In an embodiment, the connection structure 2400 may be a bonding wire that electrically connects one of the input/output pads 2210 to a corresponding one of the package upper pads 2130. Accordingly, in each of the first and second semiconductor packages 2003a and 2003b, the semiconductor chips 2200 may be electrically connected to each other using a bonding wire type, and the semiconductor chip 2200 may be electrically connected to the package upper pad 2130 of the package substrate 2100. According to an embodiment, in each of the first and second semiconductor packages 2003a and 2003b, the semiconductor chips 2200 may be electrically connected to each other by a connection structure that includes a through silicon via (TSV) instead of the connection structure 2400 of the bonding wire type.

In an embodiment, the controller 2002 and the semiconductor chip 2200 may be included in one package. For example, the controller 2002 and the semiconductor chip 2200 may be mounted on a separate interposer substrate that is different from the main substrate 2001, and the controller 2002 and the semiconductor chip 2200 may be connected to each other by a wiring of the interposer substrate.

FIG. 25 and FIG. 26 are cross-sectional views that schematically illustrate semiconductor packages according to example embodiments, respectively. FIG. 25 and FIG. 26 respectively describe embodiments of the semiconductor package 2003 of FIG. 24, and conceptually illustrate a region obtained by cutting the semiconductor package 2003 of FIG. 24 along a line I-I'.

Referring to FIG. 25, in the semiconductor package 2003, the package substrate 2100 may be a printed circuit board. The package substrate 2100 may include a package substrate body portion 2120, package upper pads 2130 at an upper surface of the package substrate body portion 2120, package lower pads 2125 disposed at a lower surface of the package substrate body portion 2120 or exposed through the lower surface of the package substrate body portion 2120, and an internal wiring 2135 electrically connecting the package upper pads 2130 and the package lower pads 2125 inside the package substrate body portion 2120. The package upper pads 2130 may be electrically connected to the connection structure 2400. The package lower pads 2125 may be connected to a wiring pattern 2005 of the main substrate 2001 of the electronic system 2000, as illustrated in FIG. 24, through conductive connection portions 2800.

The semiconductor chip 2200 may include a semiconductor substrate 3010, and a first structure 3100 and a second structure 3200 sequentially stacked on the semiconductor substrate 3010. The first structure 3100 may include a peripheral circuit region including a peripheral wiring 3110. The second structure 3200 may include a common source line 3205, a gate stacking structure 3210 on the common source line 3205, a channel structure 3220 and a separation structure 3230 penetrating the gate stacking structure 3210, a bit line 3240 electrically connected to the channel structure 3220, and a gate connection wiring electrically connected to a word line WL (refer to FIG. 23) of the gate stacking structure 3210.

In a semiconductor chip 2200 or a semiconductor device according to an embodiment, a first layer may be formed before a succeeding partial etching process, and a damage that may be induced in the succeeding partial etching process may be prevented and a through hole that has a relatively large depth may be stably formed in the succeeding partial etching process. Thereby, reliability and productivity of the semiconductor chip 2200 or the semiconductor device may be enhanced.

Each of the semiconductor chips 2200 may include a through wiring 3245 that is electrically connected to the peripheral wiring 3110 of the first structure 3100 and extends into the second structure 3200. The through wiring 3245 may penetrate the gate stacking structure 3210, and may be further provided at an outside of the gate stacking structure 3210. Each semiconductor chip 2200 may further include an input/output connection wiring 3265 electrically connected to the peripheral wiring 3110 of the first structure 3100 and extending into the second structure 3200, and an input/output pad 2210 electrically connected to the input/output connection wiring 3265.

In an embodiment, in the semiconductor package 2003, a plurality of semiconductor chips 2200 may be electrically connected to each other by a connection structure 2400 having a bonding wire type. In some embodiments, the plurality of semiconductor chips 2200 or a plurality of portions constituting the plurality of semiconductor chips 2200 may be electrically connected by a connection structure including a through silicon via (TSV).

Referring to FIG. 26, in a semiconductor package 2003A, each semiconductor chip 2200a may include a semiconductor substrate 4010, a first structure 4100 on the semiconductor substrate 4010, and a second structure 4200 disposed on the first structure 4100 and bonded to the first structure 4100 by a wafer bonding type.

The first structure 4100 may include a peripheral circuit region including a peripheral wiring 4110 and a first bonding structure 4150. The second structure 4200 may include a common source line 4205, a gate stacking structure 4210 between the common source line 4205 and the first structure 4100, a channel structure 4220 and a separation structure 4230 penetrating the gate stacking structure 4210, and a second bonding structure 4250 electrically connected to the channel structure 4220 and a word line WL (refer to FIG. 23) of the gate stacking structure 4210. For example, the second bonding structure 4250 may be electrically connected to the channel structure 4220 and the word line WL through a bit line 4240 electrically connected to the channel structure 4220 and a gate connection wiring electrically connected to the word line WL. The first bonding structure 4150 of the first structure 4100 and the second bonding structure 4250 of the second structure 4200 may be in contact with and bonded to each other. For example, portions of the first bonding structure 4150 and the second bonding structure 4250 where the first bonding structure 4150 and the second bonding structure 4250 are bonded may include copper (Cu).

In a semiconductor chip 2200a or a semiconductor device according to an embodiment, a first layer may be formed before a succeeding partial etching process, and a damage that may be induced in the succeeding partial etching process may be prevented and a through hole that has a relatively large depth may be stably formed in the succeeding partial etching process. Thereby, reliability and productivity of the semiconductor chip 2200a or the semiconductor device may be enhanced.

Each of the semiconductor chips 2200a may further include an input/output pad 2210 and an input/output connection wiring 4265 at a lower portion of the input/output pad 2210. The input/output connection wiring 4265 may be electrically connected to a part of the second bonding structure 4250.

In an embodiment, in the semiconductor package 2003A, a plurality of semiconductor chips 2200a may be electrically connected to each other by the connection structure 2400 having a bonding wire type. In some embodiments, the plurality of semiconductor chips 2200a or a plurality of portions constituting the plurality of semiconductor chips 2200a may be electrically connected by a connection structure including a through silicon via (TSV).

While some examples have been described in connection with what is presently considered to be some practical embodiments, it is to be understood that the disclosure is not limited to the disclosed embodiments, and that that the disclosure is intended to cover various modifications and equivalent arrangements included within the scope of the appended claims.

## Claims

1. A semiconductor device, comprising:
a memory cell structure in a cell array region (102);
an electrode stacking structure (120) that includes a plurality of electrodes (130) and a plurality of interlayer insulation layers (132) alternately stacked on each other at least in a connection region (104); and
a plurality of electrode contact portions (190) that pass through or penetrate at least a partial portion of the electrode stacking structure (120) and are electrically connected to the plurality of electrodes (130), respectively,
wherein the plurality of electrode contact portions (190) include:
a first contact portion (192) that includes a first conductive portion (192c), and a first side insulation layer (192i) between the electrode stacking structure (120) and the first conductive portion (192c); and
a second contact portion (196) that includes a second conductive portion (196c), and a second side insulation layer (196i) between the electrode stacking structure (120) and the second conductive portion (196c), and
wherein the second side insulation layer (196i) has a shape or a structure different from a shape or a structure of the first side insulation layer (192i).

2. The semiconductor device of claim 1, further comprising:
a plurality of through holes (PH) that separately or individually pass through or penetrate the electrode stacking structure (120) and are spaced apart from each other while interposing the electrode stacking structure (120),
wherein the plurality of electrode contact portions (190) are disposed in the plurality of through holes (PH), respectively.

3. The semiconductor device of claim 1 or 2, wherein the first side insulation layer (192i) includes a first portion (R1), and a second portion (R2) that has a thickness (T2) less than a thickness (T1) of the first portion (R1).

4. The semiconductor device of claim 3,
wherein the first contact portion (192) includes a plurality of first contact portions (192) having different depths,
wherein the second contact portion (196) includes a plurality of second contact portions (196) having different depths, and
wherein a depth of each of the plurality of first contact portions (192) is greater than a depth of each of the plurality of second contact portions (196).

5. The semiconductor device of claim 3 or 4,
wherein the first portion (R1) of the first side insulation layer (192i) is disposed at an upper portion of the first contact portion (192) and is spaced apart from a lower surface of the first contact portion (192), and
wherein the second portion (R2) of the first side insulation layer (192i) is disposed at a lower portion of the first portion (R1) or under the first portion (R1).

6. The semiconductor device of any one of claims 3 to 5, wherein the first portion (R1) of the first side insulation layer (192i) is spaced apart from a lower surface of the first contact portion (192) while interposing a portion corresponding to at least one of the plurality of electrodes (130).

7. The semiconductor device of any one of claims 3 to 6, wherein, in the first contact portion (192), a number of electrodes of the plurality of electrodes (130) that correspond to the second portion (R2) is greater than a number of electrodes of the plurality of electrodes (130) that correspond to the first portion (R1).

8. The semiconductor device of any one of claims 3 to 7,
wherein an inner side surface of the first side insulation layer (192i) includes an inclined surface or a vertical surface that is inclined or parallel to a vertical direction (Z), and
wherein an outer side surface of the first side insulation layer (192i) includes an inclined surface or a vertical surface that is inclined or parallel to the vertical direction (Z) and has a step (S) due to a thickness difference (TD) between the first portion (R1) and the second portion (R2).

9. The semiconductor device of any one of claims 3 to 8, wherein, in a direction perpendicular to a side surface of the first side insulation layer (192i), a difference (TD) between a thickness (T1) of the first portion (R1) and a thickness (T2) of the second portion (R2) is 0.5nm or more.

10. The semiconductor device of any one of claims 3 to 9,
wherein, in a direction perpendicular to a side surface of the first side insulation layer (192i), a ratio of a thickness (T2) of the second portion (R2) to a thickness (T1) of the first portion (R1) is in a range from 0.5 to 1, and/or
wherein, in the direction perpendicular to the side surface of the first side insulation layer (192i), a difference (TD) between the thickness (T1) of the first portion (R1) and the thickness (T2) of the second portion (R2) is less than the thickness (T2) of the second portion (R2).

11. The semiconductor device of any one of claims 3 to 10, wherein a difference between a thickness (T1) of the first portion (R1) and a thickness (T2) of the second portion (R2) in a direction perpendicular to a side surface of the first side insulation layer (192i) is less than a thickness of one of the plurality of interlayer insulation layers (132) and/or a thickness of one of the plurality of electrodes (130).

12. The semiconductor device of any one of claims 3 to 11, wherein the second side insulation layer (196i) includes a portion that has a materialand/or a structure and/or a thickness that is the same as a material and/or a structure and/or a thickness of the first portion (R1) in an entire portion.

13. The semiconductor device of any one of claims 3 to 12,
wherein the first portion (R1) includes a first insulation portion (IR1), and a second insulation portion (IR2) that has a thickness less than a thickness of the first insulation portion (IR1) and is disposed between the first insulation portion (ISR2) and the second portion (R2).

14. The semiconductor device of any one of claims 1 to 13,
wherein each of the first and second side insulation layers (192i, 196i) includes a first layer (190a) on a side surface of the electrode stacking structure (120) and a second layer (190b) on the first layer (190a), and
wherein an arrangement or a relative position of the first layer (190a) and the second layer (190b) in the first side insulation layer (192i) is different from an arrangement or a relative position of the first layer (190a) and the second layer (190b) in the second side insulation layer (196i).

15. The semiconductor device of claim 14,
wherein the first layer (190a) and the second layer (190b) include the same material or include different materials,
wherein the first layer (190a) includes or is formed of silicon oxide, silicon oxynitride, a low dielectric constant material having a lower dielectric constant than silicon oxide, or a combination thereof, and
wherein the second layer (190b) includes or is formed of silicon oxide, silicon nitride, silicon oxynitride, a low dielectric constant material having a lower dielectric constant than silicon oxide, or a combination thereof.
